(19) Europäisches Patentamt
European Patent Office
Office européen des brevets

(11) EP 4 390 422 A1

(12) EUROPEAN PATENT APPLICATION
published in accordance with Art. 153(4) EPC

(43) Date of publication:
**26.06.2024 Bulletin 2024/26**

(21) Application number: **22858541.0**

(22) Date of filing: **19.08.2022**

(51) International Patent Classification (IPC):
***G01R 31/392*** *(2019.01)* ***H01M 10/48*** *(2006.01)*
***H02J 7/00*** *(2006.01)*

(52) Cooperative Patent Classification (CPC):
**G01R 31/392; H01M 10/48; H02J 7/00;** Y02E 60/10

(86) International application number:
**PCT/JP2022/031360**

(87) International publication number:
**WO 2023/022224 (23.02.2023 Gazette 2023/08)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.08.2021 JP 2021134408**

(71) Applicant: **Eliiy Power Co., Ltd.**
**Tokyo 141-0032 (JP)**

(72) Inventors:
- **SUGIYAMA, Hideyuki**
  **Tokyo 141-0032 (JP)**
- **MIYAZAKI, Takahiro**
  **Tokyo 141-0032 (JP)**

(74) Representative: **Strehl Schübel-Hopf & Partner**
**Maximilianstrasse 54**
**80538 München (DE)**

(54) **SECONDARY BATTERY CAPACITY RETENTION RATIO ESTIMATING METHOD, SECONDARY BATTERY CAPACITY RETENTION RATIO ESTIMATING PROGRAM, AND SECONDARY BATTERY CAPACITY RETENTION RATIO ESTIMATING DEVICE**

(57) In a secondary battery state of health estimation method, which estimates the state of health (SOH) of a secondary battery by use of a Weibull law, the total capacity retention rate of the secondary battery, obtained from at least one of data on the secondary battery in operation and a cycle test, is separated into a float capacity retention rate ascribed to deterioration dependent on a use period, and a cycle capacity retention rate ascribed to deterioration dependent on the number of charges/discharges; Weibull coefficients $m_f$, $\eta_f$ corresponding to the float capacity retention rate, and the float capacity retention rate represented by the following formula (1) are obtained; Weibull coefficients $m_c$, $\eta_c$ corresponding to the cycle capacity retention rate, and the cycle capacity retention rate represented by the following formula (2) are obtained; and the state of health in a period t or at a cycle number N is estimated from the following formula (A):

[Equation 1]

$$\text{Float capacity retention rate} = \exp\left\{-\left(\frac{t}{\eta_f}\right)^{m_f}\right\} \cdots (1)$$

$$\text{Cycle capacity retention rate} = \exp\left\{-\left(\frac{N}{\eta_c}\right)^{m_c}\right\} \cdots (2)$$

$$\text{State of health (SOH)} = \exp\left\{-\left(\frac{t}{\eta_f}\right)^{m_f}\right\} \times \exp\left\{-\left(\frac{N}{\eta_c}\right)^{m_c}\right\} \cdots (A)$$

EP 4 390 422 A1

Fig. 3

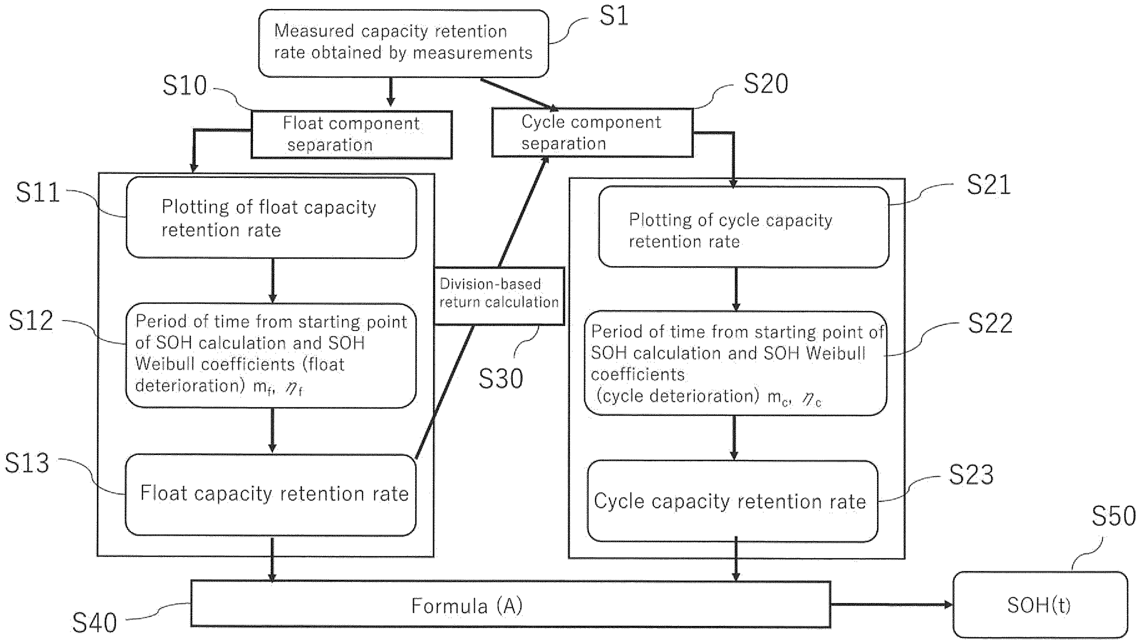
Measured capacity retention rate obtained by measurements
S1
S10
Float component separation
S20
Cycle component separation
S11
Plotting of float capacity retention rate
S12
Period of time from starting point of SOH calculation and SOH Weibull coefficients (float deterioration) $m_f$, $\eta_f$
S13
Float capacity retention rate
Division-based return calculation
S30
S21
Plotting of cycle capacity retention rate
S22
Period of time from starting point of SOH calculation and SOH Weibull coefficients (cycle deterioration) $m_c$, $\eta_c$
S23
Cycle capacity retention rate
S40
Formula (A)
S50
SOH(t)

## Description

[Technical Field]

This invention relates to a secondary battery state of health (SOH) estimation method, a secondary battery state of health estimation program, and a secondary battery state of health estimation apparatus in a storage battery system which has a storage battery composed of a rechargeable and dischargeable secondary battery cell as a single unit, or a plurality of rechargeable and dischargeable secondary battery cells connected in series or parallel, and which also has a power regulator connected to the storage battery, a commercial power source, and a power generator and capable of supplying electric power (or power) to a load to be connected.

[Background Art]

A proposal has been made for a storage battery system which accumulates power, generated using natural energy such as sunlight, in a storage battery in order to curb the use of a commercial power source, and supplies the power accumulated in the storage battery, instead of the commercial power source, to a load requiring power.

A storage battery system described as above, for example, is often used in one or two charge/discharge cycles/day, and the state of health of its secondary battery is known to decline gradually owing to cycle deterioration or aged deterioration. The capacity of the secondary battery after long-term use cannot be known unless it is actually measured. A gradual decrease in the state of health of the secondary battery, however, leads to the stoppage of the storage battery system used. To grasp the present situation of the secondary battery in operation, therefore, it is becoming necessary to predict the state of health of the secondary battery. To satisfy a requirement for reduction of environmental burden, moreover, a demand is also being voiced for extension of the usage period of the storage battery system. Thus, it is becoming necessary to predict the life of the secondary battery in the future.

Conventional methods known are one which prepares many maps showing a complicated charging state to correct the state of health, and a formula for prediction of the state of health. As the formula for prediction of the state of health, one using a root law or a power law is known. It is known that the capacity reduction rate of a secondary battery is determined according to a one-half power law (root law) which defines that the capacity reduction rate of the secondary battery is proportional to the one-half power of the flowing current amount (current integrated value) of the secondary battery, or is proportional to the one-half power of the standing time of the secondary battery. The relevant formula is as indicated below. If the square root of the flowing current amount which is the flowing current (current amount) of the secondary battery integrated over time is determined, the deterioration state (or capacity reduction rate) of the secondary batter can be estimated.

[Equation 1]

$$\text{Capacity deterioration rate} = k\sqrt{t} = kt^{0.5}$$

$$\text{Capacity retention rate} = 1 - k\sqrt{t} = 1 - kt^{0.5}$$

Furthermore, there is disclosed a technology which obtains an integrated charge amount based on the charge/discharge current over time, without interrupting power supply from a secondary battery and without discharging the secondary battery up to a discharge stoppage state, thereby making it possible to estimate the full charge capacity or remaining capacity of the secondary battery (see, for example, Patent Document 1). Relevant formulas are as follows (power law):

[Equation 2]

$$\text{Capacity deterioration rate} = kt^{n}$$

$$\text{State of health} = 1 - kt^{n}$$

However, the root law poses the problem that the values obtained thereby deviate greatly from actual measurements. On the other hand, the power law shows a good fitting, but similarly causes a deviation from the actual value. Besides, both the root law and the power law mathematically give values which can be less than a state of health of 0%.

Thus, the problem arises that predicted values in long-term prediction are below measured values.

The inventors, therefore, proposed a novel state of health estimation method using the Weibull law (see Non-Patent Document 1). Such a method grasps a battery as an assembly of partial batteries, and enables life to be estimated by prediction of its failure rate. This method is represented by the following formulas:

[Equation 3]

$$\text{Capacity deterioration rate} = 1 - \exp\{-\left(\frac{t}{\eta}\right)^{m}\}$$

$$\text{State of health} = \exp\{-\left(\frac{t}{\eta}\right)^{m}\}$$

[Prior Art Documents]

[Patent Documents]

[Patent Document 1] JP-A-2009-52974

[Non-Patent Documents]

[Non-Patent Document 1] Abstracts of Presentations, The 59th Battery Symposium in Japan, P212, published on November 26, 2018

[Summary of the Invention]

[Problems to be solved by the invention]

The above state of health estimation method using the Weibull law provides results coincident satisfactorily with measured values in comparison with the root law or the power law, but brings about great errors in connection with long-term prediction. Its practical utilization, therefore, requires more accurate life prediction.

The present invention has been accomplished in the light of the above-mentioned circumstances. It is an object of this invention to provide a secondary battery state of health estimation method, a secondary battery state of health estimation program, and a secondary battery state of health estimation apparatus which estimate the state of health (SOH) of a secondary battery accurately for a longer period of time.

[Means for Solving the Problems]

A first aspect of the present invention, designed to solve the above-mentioned problems, resides in a secondary battery state of health estimation method, which estimates the state of health (SOH) of a secondary battery by use of a Weibull law, comprising:

separating a total capacity retention rate of the secondary battery, obtained from at least one of data on the secondary battery in operation and a cycle test, into a float capacity retention rate ascribed to deterioration dependent on a use period, and a cycle capacity retention rate ascribed to deterioration dependent on a number of charges/discharges;
obtaining Weibull coefficients $m_f$, $\eta_f$ corresponding to the float capacity retention rate, and the float capacity retention rate represented by the following formula (1);
obtaining Weibull coefficients $m_c$, $\eta_c$ corresponding to the cycle capacity retention rate, and the cycle capacity retention rate represented by the following formula (2); and
estimating the state of health in a period t or at a cycle number N from the following formula (A):

[Equation 4]

$$\text{Float capacity retention rate} = \exp\left\{-\left(\frac{t}{\eta_f}\right)^{m_f}\right\} \cdots (1)$$

$$\text{Cycle capacity retention rate} = \exp\left\{-\left(\frac{N}{\eta_c}\right)^{m_c}\right\} \cdots (2)$$

$$\text{State of health (SOH)} = \exp\left\{-\left(\frac{t}{\eta_f}\right)^{m_f}\right\} \times \exp\left\{-\left(\frac{N}{\eta_c}\right)^{m_c}\right\} \cdots (A)$$

A second aspect of the present invention resides in the secondary battery state of health estimation method according to the first aspect, comprising:
obtaining the float capacity retention rate from measurement values of a float test; and separating a measured total capacity retention rate obtained from the data on the secondary battery in operation, or a total cycle test capacity retention rate obtained from measurement values of the cycle test, as the total capacity retention rate, into the float capacity retention rate and the cycle capacity retention rate.

A third aspect of the present invention resides in the secondary battery state of health estimation method according to the second aspect, comprising:

Weibull plotting the float capacity retention rate in relation to ln(period) and ln(ln(1/ capacity retention rate)) to prepare a Weibull plot of the float capacity retention rate;
estimating a float deterioration prediction line, represented by a straight-line equation, from the Weibull plot of the float capacity retention rate;
obtaining $m_f$ and $\eta_f$ from a slope and an intercept of the float deterioration prediction line;
determining the float capacity retention rate from the $m_f$ and $\eta_f$ and the formula (1);
dividing the total capacity retention rate by the float capacity retention rate to calculate the cycle capacity retention rate;
Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

A fourth aspect of the present invention resides in the secondary battery state of health estimation method according to the first aspect, comprising:
obtaining the float capacity retention rate from measurement values of the cycle test; and separating a measured total capacity retention rate obtained from the data on the secondary battery in operation, or a total cycle test capacity retention rate obtained from the measurement values of the cycle test, as the total capacity retention rate, into the float capacity retention rate and the cycle capacity retention rate.

A fifth aspect of the present invention resides in the secondary battery state of health estimation method according to the fourth aspect, comprising:

Weibull plotting the total capacity retention rate in relation to ln(period) and ln(ln(1/ capacity retention rate)) to prepare a Weibull plot of the total capacity retention rate;
polynomial fitting the Weibull plot of the total capacity retention rate to find a polynomial representing a curve;
finding a tangent to the polynomial during an initial predetermined period;
obtaining $m_f$ and $\eta_f$ from a slope and an intercept of the tangent;
determining the float capacity retention rate from the $m_f$ and $\eta_f$ and the formula (1);
dividing the total capacity retention rate by the float capacity retention rate to calculate the cycle capacity retention rate;
Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

A sixth aspect of the present invention resides in the secondary battery state of health estimation method according to the fourth aspect, comprising:

Weibull plotting the total capacity retention rate in relation to ln(period) and ln(ln(1/ capacity retention rate)) to prepare a Weibull plot of the total capacity retention rate;
polynomial fitting the Weibull plot of the total capacity retention rate to find a polynomial representing a curve;
finding a slope from two points on the Weibull plot during an initial predetermined period in the polynomial;
finding a tangent to the polynomial having the slope;
obtaining $m_f$ and $\eta_f$ from a slope and an intercept of the tangent;
determining the float capacity retention rate from the $m_f$ and $\eta_f$ and the formula (1);
dividing the total capacity retention rate by the float capacity retention rate to calculate the cycle capacity retention rate;
Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

A seventh aspect of the present invention resides in the secondary battery state of health estimation method according to the first aspect, comprising:
determining the float capacity retention rate from a measured total capacity retention rate obtained from the data on the secondary battery in operation; and separating the measured total capacity retention rate obtained from the data on the secondary battery in operation, or a total cycle test capacity retention rate obtained from measurement values of the cycle test, as the total capacity retention rate, into the float capacity retention rate and the cycle capacity retention rate.

An eighth aspect of the present invention resides in the secondary battery state of health estimation method according to the seventh aspect, comprising:

Weibull plotting the measured total capacity retention rate in relation to ln(period) and ln(ln(1/ capacity retention rate)) to prepare a Weibull plot of the measured total capacity retention rate;
polynomial fitting the Weibull plot of the measured total capacity retention rate to find a polynomial representing a curve;
finding a tangent to the polynomial during an initial predetermined period;
obtaining $m_f$ and $\eta_f$ from a slope and an intercept of the tangent;
determining the float capacity retention rate from the $m_f$ and $\eta_f$ and the formula (1);
dividing the total capacity retention rate by the float capacity retention rate to calculate the cycle capacity retention rate;
Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

A ninth aspect of the present invention resides in the secondary battery state of health estimation method according to the seventh aspect, comprising:

Weibull plotting the measured total capacity retention rate in relation to ln(period) and ln(ln(1/ capacity retention rate)) to prepare a Weibull plot of the measured total capacity retention rate;
polynomial fitting the Weibull plot of the measured total capacity retention rate to find a polynomial representing a curve;
finding a slope from two points on the Weibull plot during an initial predetermined period in the polynomial;
finding a tangent to the polynomial having the slope;
obtaining $m_f$ and $\eta_f$ from a slope and an intercept of the tangent;
determining the float capacity retention rate from the $m_f$ and $\eta_f$ and the formula (1);
dividing the total capacity retention rate by the float capacity retention rate to calculate the cycle capacity retention rate;

Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

A tenth aspect of the present invention resides in a secondary battery state of health estimation program, which estimates the state of health (SOH) of a secondary battery by use of a Weibull law,
the program comprising making a computer work to perform:

a step of separating a total capacity retention rate of the secondary battery, obtained from at least one of data on the secondary battery in operation, a cycle test, and a float test, into a float capacity retention rate ascribed to deterioration dependent on a use period, and a cycle capacity retention rate ascribed to deterioration dependent on a number of charges/discharges;
a step of obtaining Weibull coefficients $m_f$, $\eta_f$ corresponding to the float capacity retention rate, and the float capacity retention rate represented by the following formula (1);
a step of obtaining Weibull coefficients $m_c$, $\eta_c$ corresponding to the cycle capacity retention rate, and the cycle capacity retention rate represented by the following formula (2); and
a step of estimating the state of health in a period t or at a cycle number N from the following formula (A):

[Equation 5]

$$\text{Float state of health} = \exp\left\{-\left(\frac{t}{\eta_f}\right)^{m_f}\right\} \cdots (1)$$

$$\text{Cycle state of health} = \exp\left\{-\left(\frac{N}{\eta_c}\right)^{m_c}\right\} \cdots (2)$$

$$\text{State of health (SOH)} = \exp\left\{-\left(\frac{t}{\eta_f}\right)^{m_f}\right\} \times \exp\left\{-\left(\frac{N}{\eta_c}\right)^{m_c}\right\} \cdots (A)$$

An eleventh aspect of the present invention resides in the secondary battery state of health estimation program according to the tenth aspect,
the program comprising making a computer work to perform:
a step of obtaining the float capacity retention rate from measurement values of the float test; and separating a measured total capacity retention rate obtained from the data on the secondary battery in operation, or a total cycle test capacity retention rate obtained from measurement values of the cycle test, as the total capacity retention rate, into the float capacity retention rate and the cycle capacity retention rate.
A twelfth aspect of the present invention resides in the secondary battery state of health estimation program according to the eleventh aspect,
the program comprising making a computer work to perform:

a step of Weibull plotting the float capacity retention rate in relation to ln(period) and ln(ln(1/ capacity retention rate)) to prepare a Weibull plot of the float capacity retention rate;
a step of estimating a float deterioration prediction line, represented by a straight-line equation, from the Weibull plot of the float capacity retention rate;
a step of obtaining the Weibull coefficients $m_f$ and $\eta_f$ from a slope and an intercept of the float deterioration prediction line;
a step of determining the float capacity retention rate from the Weibull coefficients $m_f$ and $\eta_f$ and the formula (1);
a step of dividing the total capacity retention rate by the float capacity retention rate to calculate the cycle capacity retention rate;

a step of Weibull plotting the cycle capacity retention rate in relation to ln(cycle number) and ln(ln(1/ capacity retention rate)) to prepare a Weibull plot of the cycle capacity retention rate;
a step of estimating a cycle deterioration prediction line, represented by a straight-line equation, from the Weibull plot of the cycle capacity retention rate;
a step of obtaining Weibull coefficients $m_c$ and $\eta_c$ from a slope and an intercept of the cycle deterioration prediction line; and
a step of determining the cycle capacity retention rate from the Weibull coefficients $m_c$ and $\eta_c$ and the formula (2).

A thirteenth aspect of the present invention resides in the secondary battery state of health estimation program according to the tenth aspect,
the program comprising making a computer work to perform:
a step of obtaining the float capacity retention rate from measurement values of the cycle test; and separating a measured total capacity retention rate obtained from the data on the secondary battery in operation, or a total cycle test capacity retention rate obtained from the measurement values of the cycle test, as the total capacity retention rate, into the float capacity retention rate and the cycle capacity retention rate.
A fourteenth aspect of the present invention resides in the secondary battery state of health estimation program according to the thirteenth aspect,
the program comprising making a computer work to perform:

a step of Weibull plotting the total capacity retention rate in relation to ln(period) and ln(ln(1/ capacity retention rate)) to prepare a Weibull plot of the total capacity retention rate;
a step of polynomial fitting the Weibull plot of the total capacity retention rate to find a polynomial representing a curve;
a step of finding a tangent to the polynomial during an initial predetermined period;
a step of obtaining Weibull coefficients $m_f$ and $\eta_f$ from a slope and an intercept of the tangent;
a step of determining the float capacity retention rate from the $m_f$ and $\eta_f$ and the formula (1);
a step of dividing the total capacity retention rate by the float capacity retention rate to calculate the cycle capacity retention rate;
a step of Weibull plotting the cycle capacity retention rate in relation to ln(cycle number) and ln(ln(1/ capacity retention rate)) to prepare a Weibull plot of the cycle capacity retention rate; and
a step of estimating a cycle deterioration prediction line, represented by a straight-line equation, from the Weibull plot of the cycle capacity retention rate, obtaining Weibull coefficients $m_c$ and $\eta_c$ from a slope and an intercept of the cycle deterioration prediction line, and determining the cycle capacity retention rate from the $m_c$ and $\eta_c$ and the formula (2).

A fifteenth aspect of the present invention resides in the secondary battery state of health estimation program according to the thirteenth aspect,
the program comprising making a computer work to perform:

a step of Weibull plotting the total capacity retention rate in relation to ln(period) and ln(ln(1/ capacity retention rate)) to prepare a Weibull plot of the total capacity retention rate;
a step of polynomial fitting the Weibull plot of the total capacity retention rate to find a polynomial representing a curve;
a step of finding a slope from two points on the Weibull plot during an initial predetermined period in the polynomial;
a step of finding a tangent to the polynomial having the slope, and obtaining Weibull coefficients $m_f$ and $\eta_f$ from a slope and an intercept of the tangent;
a step of determining the float capacity retention rate from the $m_f$ and $\eta_f$ and the formula (1);
a step of dividing the total capacity retention rate by the float capacity retention rate to calculate the cycle capacity retention rate;
a step of Weibull plotting the cycle capacity retention rate in relation to ln(cycle number) and ln(ln(1/ capacity retention rate)) to prepare a Weibull plot of the cycle capacity retention rate;
a step of estimating a cycle deterioration prediction line, represented by a straight-line equation, from the Weibull plot of the cycle capacity retention rate; and
a step of obtaining Weibull coefficients $m_c$ and $\eta_c$ from a slope and an intercept of the cycle deterioration prediction line, and determining the cycle capacity retention rate from the $m_c$ and $\eta_c$ and the formula (2).

A sixteenth aspect of the present invention resides in the secondary battery state of health estimation program according to the tenth aspect,
the program comprising making a computer work to perform:
a step of determining the float capacity retention rate from a measured total capacity retention rate obtained from the data on the secondary battery in operation, and separating the measured total capacity retention rate obtained from the data on the secondary battery in operation, or a total cycle test capacity retention rate obtained from measurement values of the cycle test, as the total capacity retention rate, into the float capacity retention rate and the cycle capacity retention rate.

A seventeenth aspect of the present invention resides in the secondary battery state of health estimation program according to the sixteenth aspect,
the program comprising making a computer work to perform:

a step of Weibull plotting the measured total capacity retention rate in relation to ln(period) and ln(ln(1/ capacity retention rate)) to prepare a Weibull plot of the measured total capacity retention rate;
a step of polynomial fitting the Weibull plot of the measured total capacity retention rate to find a polynomial representing a curve;
a step of finding a tangent to the polynomial during an initial predetermined period;
obtaining Weibull coefficients $m_f$ and $\eta_f$ from a slope and an intercept of the tangent;
a step of determining the float capacity retention rate from the $m_f$ and $\eta_f$ and the formula (1);
a step of dividing the total capacity retention rate by the float capacity retention rate to calculate the cycle capacity retention rate;
a step of Weibull plotting the cycle capacity retention rate in relation to ln(cycle number) and ln(ln(1/ capacity retention rate)) to prepare a Weibull plot of the cycle capacity retention rate;
a step of estimating a cycle deterioration prediction line, represented by a straight-line equation, from the Weibull plot of the cycle capacity retention rate; and
a step of obtaining Weibull coefficients $m_c$ and $\eta_c$ from a slope and an intercept of the cycle deterioration prediction line, and determining the cycle capacity retention rate from the $m_c$ and $\eta_c$ and the formula (2).

An eighteenth aspect of the present invention resides in the secondary battery state of health estimation program according to the sixteenth aspect,
the program comprising making a computer work to perform:

a step of Weibull plotting the measured total capacity retention rate in relation to ln(period) and ln(ln(1/ capacity retention rate)) to prepare a Weibull plot of the measured total capacity retention rate;
a step of polynomial fitting the Weibull plot of the measured total capacity retention rate to find a polynomial representing a curve;
a step of finding a slope from two points on the Weibull plot during an initial predetermined period in the polynomial;
a step of finding a tangent to the polynomial having the slope, and obtaining Weibull coefficients $m_f$ and $\eta_f$ from a slope and an intercept of the tangent;
a step of determining the float capacity retention rate;
a step of dividing the total capacity retention rate by the float capacity retention rate to calculate the cycle capacity retention rate;
a step of Weibull plotting the cycle capacity retention rate in relation to ln(cycle number) and ln(ln(1/ capacity retention rate)) to prepare a Weibull plot of the cycle capacity retention rate;
a step of estimating a cycle deterioration prediction line, represented by a straight-line equation, from the Weibull plot of the cycle capacity retention rate; and
a step of obtaining Weibull coefficients $m_c$ and $\eta_c$ from a slope and an intercept of the cycle deterioration prediction line, and determining the cycle capacity retention rate from the $m_c$ and $\eta_c$ and the formula (2).

A nineteenth aspect of the present invention resides in a secondary battery state of health estimation apparatus, which performs a secondary battery state of health estimation method to estimate a state of health (SOH) of a secondary battery, the apparatus comprising:

storage means storing data on at least one of a cycle test and a float test; and
data acquisition means for acquiring data on the secondary battery in operation, a period t, and a cycle number N from the secondary battery;
the apparatus executing
a step of separating a total capacity retention rate of the secondary battery, obtained from at least one of data on the secondary battery in operation and the cycle test, into a float capacity retention rate ascribed to deterioration dependent on a use period, and a cycle capacity retention rate ascribed to deterioration dependent on a number of charges/discharges;
a step of obtaining Weibull coefficients $m_f$, $\eta_f$ corresponding to the float capacity retention rate, and the float capacity retention rate represented by the following formula (1);
a step of obtaining Weibull coefficients $m_c$, $\eta_c$ corresponding to the cycle capacity retention rate, and the cycle capacity retention rate represented by the following formula (2); and
a step of estimating the state of health in the period t or at the cycle number N from the following formula (A):

[Equation 6]

$$\text{Float capacity retention rate} = \exp\left\{-\left(\frac{t}{\eta_f}\right)^{m_f}\right\} \cdots (1)$$

$$\text{Cycle capacity retention rate} = \exp\left\{-\left(\frac{N}{\eta_c}\right)^{m_c}\right\} \cdots (2)$$

$$\text{State of health (SOH)} = \exp\left\{-\left(\frac{t}{\eta_f}\right)^{m_f}\right\} \times \exp\left\{-\left(\frac{N}{\eta_c}\right)^{m_c}\right\} \cdots (A)$$

[Effects of the Invention]

According to the present invention, there can be provided a secondary battery state of health estimation method, a secondary battery state of health estimation program, and a secondary battery state of health estimation apparatus, which separate the state of health of a secondary battery into a float component ascribed to deterioration dependent on an elapsed time, and a cycle component ascribed to deterioration dependent on the number of charges/discharges, thereby estimating the state of health of the secondary battery accurately for a long period of time.

[Brief Description of the Drawings]

[Fig. 1] is a view showing the schematic configuration of a storage battery system, as an example of a secondary battery, to which the method of the present invention is applied.
[Fig. 2] is a functional block diagram showing an example of the schematic configuration of a control unit in Fig. 1.
[Fig. 3] is a schematic flow diagram of the method of the present invention.
[Fig. 4] is a view showing an example of a Weibull plot of the results of a float test.
[Figs. 5(a) to 5(c)] are views illustrating a technique for obtaining a cycle capacity retention rate by division-based return calculation.
[Fig. 6] is a view showing Weibull plotting of a cycle total capacity retention rate in relation to a period t.
[Fig. 7] is a view illustrating an example in which points on the Weibull plot are subjected to polynomial fitting to find a curve equation, and the resulting polynomial is differentiated to find the slope of a tangent thereto.
[Fig. 8] is a view illustrating an example in which Weibull coefficients $m_f$, $\eta_f$ are obtained from a slope and an intercept of a prediction line of a float deterioration component.
[Fig. 9] is a view illustrating an example in which the cycle capacity retention rate is Weibull plotted in relation to a cycle number N.
[Fig. 10] is a view illustrating an example in which Weibull coefficients $m_c$, $\eta_c$ are obtained from a slope and an intercept of a prediction line of a cycle deterioration component.
[Fig. 11] is a view showing the results of Example 1.
[Fig. 12] is a view showing the results of Example 2.
[Fig. 13] is a view showing the results of Example 3.
[Fig. 14] is a view showing a comparison between predicted values and measured values for long-term cycles in Example 1.
[Fig. 15] is a view showing the results of comparisons between predicted values in long-term prediction and measured values for Example 2.
[Fig. 16] is a view showing the results of Example 4.

[Fig. 17] is a view showing the results of Example 5.

[Mode for Carrying Out the Invention]

The present invention will be described in detail below based on its embodiments.

(Embodiment 1)

Fig. 1 is a view showing an example of the schematic configuration of a storage battery system, a subject for which the method of the present invention is carried out. As shown in Fig. 1, a storage battery system 1 is equipped with a storage battery 2, which is a secondary battery storing electric power (or power), and a power regulator 3. To the power regulator 3 are connected a commercial power source 4, a load 5, and further a solar power generation device 6 as a generator for generating power, for example, using natural energy.

The storage battery 2 is configured to be capable of charging and discharging power, and is constituted by a single or a plurality of rechargeable and dischargeable secondary battery cell(s) 2a. As the secondary battery cell 2a constituting the storage battery 2, a lithium ion battery, a nickel-metal hydride battery, a nickel-cadmium battery, or a lead-acid battery, for example, can be used. In the present embodiment, a lithium ion battery is used as the storage battery 2. The plurality of secondary battery cells 2a are connected based on functions and capabilities required of a storage battery, and may be connected in series or in parallel.

The power regulator 3 is a so-called power conditioner, and has an inverter 30 for rectifying alternating current power supplied from the commercial power source 4, and converting direct current power from the storage battery 2 or the solar power generation device 6 into alternating current power and outputting it to the load 5; a plurality of switches (first switch 31 to fifth switch 35); and a control unit 30 for exercising overall control over the power regulator 3. In the present embodiment, the inverter 30 serves as a bidirectional inverter having the function of converting the inputted direct current power to alternating current power and outputting it, and the function of converting the inputted alternating current power to direct current power and outputting it.

The commercial power source 4 is supplied with power from an electricity provider and, in the present embodiment, is supplied with alternating current power.

A power generator is a device for generating power by using natural energy (renewable energy) such as sunlight, solar heat, water power, wind power, geothermal heat, wave power, temperature difference, or biomass. In the present embodiment, the solar power generation device 6 is used as the power generator.

The power regulator 3 of the storage battery system 1 mentioned above has the control unit 40 exercise such control as to convert direct current power, which has been generated by the solar power generation device 6, to alternating current via the storage battery 2 and the inverter 30 and supply it to the load 5 at a desired timing in a desired proportion. The power regulator 3 also has the control unit 40 exercise such control as to convert alternating current power, which has been supplied from the commercial power source 4, to direct current via the load 5 and the inverter 30 and supply it to the storage battery 2 at a desired timing.

Furthermore, the power regulator 3 is provided with the plurality of switches (the first switch 31 to the fifth switch 35) which are switching devices openable and closable under the control of the control unit 40. Concretely, the power regulator 3 includes the first switch 31 provided between the solar power generation device 6 and the inverter 30, the second switch 32 provided between the inverter 30 and the storage battery 2, the third switch 33 provided between a junction 50 of the commercial power source 4 and the load 5 and the inverter 30, the fourth switch 34 provided between the junction 50 and the commercial power source 4, and the fifth switch 35 provided between the junction 50 and the load 5. The control unit 40 controls the opening and closing of the first switch 31 to the fifth switch 35 to perform charging to and discharging from the storage battery 2, control over the receiver from the commercial power source 4, and so on. That is, the first switch 31 to the fifth switch 35 can be controlled by the control unit 40. As the fifth switch 35, there may be one which uses a molded case circuit breaker (breaker) without control by the control unit 40.

Here, the control unit 40 of the power regulator 3 will be described further by reference to Fig. 2. Fig. 2 is a functional block diagram showing the schematic configuration of the control unit 40.

As shown in Fig. 2, the control unit 40 controls the whole of the power regulator 3, and is equipped with a power generator monitoring means 41, a storage battery monitoring means 42, and a charge/discharge control means 43.

The power generator monitoring means 41 detects the power generation status of the solar power generation device 6. That is, the power generator monitoring means 41 detects whether or not the solar power generation device 6 is in a state of power generation by sunlight. The power generator monitoring means 41 may also detect the amount of power generation in the power generation state of the solar power generation device 6.

The storage battery monitoring means 42 measures the charge/discharge current, the voltage, the ambient temperature or battery temperature, the operating time, the cycle number, etc. of the storage battery 2, to estimate its SOC, SOH, etc. Moreover, the storage battery monitoring means 42 of the present embodiment functions as a monitor for monitoring the voltage, current, temperature, etc. of each secondary battery cell 2a or each battery cell group composed of the plurality of secondary battery cells 2a (i.e., CMU: Cell Monitor Unit). The storage battery monitoring means 42 senses an abnormality in the voltage, current, temperature, etc. of the secondary battery cell 2a or the group of the plurality of secondary battery cells 2a, and communicates the occurrence of the abnormality to the charge/discharge control means 43.

The charge/discharge control means 43 controls the inverter 30 and the first switch 31 to the fifth switch 35 based on various conditions, thereby controlling the charging/discharging of the storage battery 2 and the power supply from the commercial power source 4.

The power generator monitoring means 41, the storage battery monitoring means 42, and the charge/discharge control means 43 described above can be realized by a central processor (CPU: Central Processing Unit) constituting the power regulator 3, a memory capable of reading and writing (RAM: Random Access Memory), which is an example of storage means, and a memory dedicated to reading (ROM: Read Only Memory) for storing various programs, although not shown.

The method of the present invention is applied, with the aforementioned storage battery system being targeted. It goes without saying, however, that the target intended is not limited to such a storage battery system.

The method of the present invention is intended for a secondary battery in actual use, and estimates the state of health of the secondary battery. That is, the method acquires data, such as the temperature, current, voltage, operating time, and cycle number of the secondary battery in operation, and estimates the state of health (SOH) based on the data.

The above method of the present invention may be performed by the storage battery monitoring means 42. However, the data gathered by the storage battery monitoring means 42 may be transmitted to an external arithmetic unit, and the method of the present invention may be performed by the arithmetic unit acquiring the data.

A secondary battery state of health estimation apparatus, which performs the above method of the present invention, is equipped with, for example, a storage means storing data on at least one of a cycle test and a float test, a data acquisition means for acquiring data on the secondary battery in operation, a period t, and a cycle number N from the secondary battery, and an arithmetic unit for performing various arithmetic operations.

The storage means, the data acquisition means, and the arithmetic unit are preferably those of a server to be connected via a network such as the Internet, but may be computers connected to a network.

In the present invention, the terminology is used as defined below.

The state of health (SOH) of a secondary battery is separated into a float component ascribed to deterioration due to the use of the secondary battery, and a cycle component ascribed to deterioration due to charges/discharges, and the capacity retention rate ascribed to deterioration dependent on a use period is designated as a float capacity retention rate, while the capacity retention rate ascribed to deterioration dependent on the number of charges/discharges is designated as a cycle capacity retention rate.

Furthermore, the state of health of the secondary battery includes the following in addition to the state of health estimated by the present invention:

A measured total state of health: To be obtained from the data on the secondary battery in operation.

A total cycle test state of health: To be obtained from measurement values of the cycle test.

The measured total capacity retention rate and the total cycle test capacity retention rate obtained from measurements include the float component and the cycle component, and are collectively called a total capacity retention rate. The measurement values of the float test include only the float component, and are not included in the total capacity retention rate.

A schematic flow diagram of the method of the present invention will be shown in Fig. 3.

According to the present invention, the measured state of health of a secondary battery, which is obtained from the data on the secondary battery in operation, a cycle test, and a float test, is separated into a float capacity retention rate ascribed to deterioration dependent on a use period, and a cycle capacity retention rate ascribed to deterioration dependent on the number of charges/discharges.

As shown in Fig. 3, the method of the present invention determines a total capacity retention rate such as a measured total capacity retention rate or a total cycle test capacity retention rate, or if necessary, a measured capacity retention rate combined with a float test capacity retention rate obtained by a float test (Step S1). Then, a float component separation step (Step S10) and a cycle component separation step (Step S20) are performed.

In connection with the float component separation step S10, there are performed a step of plotting the float capacity retention rate (Step S11), a step of determining a period of time from the starting point of SOH calculation, and SOH Weibull coefficients (float deterioration) $m_f$, $\eta_f$ (Step S12), and a step of determining the float capacity retention rate (Step S13).

In connection with the cycle component separation step S20, on the other hand, there are performed a step of plotting the cycle capacity retention rate (Step S21), a step of determining a period of time from the starting point of SOH calculation, and SOH Weibull coefficients (cycle deterioration) $m_c$, $\eta_c$ (Step S22), and a step of determining the cycle capacity retention rate (Step S23).

The plotting of the cycle capacity retention rate in Step S21 can be performed, as an example, by executing a step of performing division-based return calculation, i.e., the act of dividing the total capacity retention rate by the float capacity retention rate (Step S30).

The float capacity retention rate is represented by a formula (1) indicated below, while the cycle capacity retention rate is represented by a formula (2) indicated below.

With the present invention, an estimation formula (A) for the capacity retention rate shown below is used (Step S40) to estimate the capacity retention rate (SOH(t)) of a battery cell or the like as a subject (Step S50).

In the above-mentioned storage battery system, the storage battery monitoring means 42 acquires the temperature, current, voltage, operating time, etc. of each secondary battery cell 2a or each battery cell group composed of the plurality of secondary battery cells 2a and, by use of these parameters, estimates the state of health of the subject battery cell or the like by the estimation formula (A) for the state of health (SOH) indicated below.

In utilizing the estimation formula (A) for the state of health, it is preferred to obtain Weibull coefficients $m_f$, $\eta_f$, $m_c$ and $\eta_c$ beforehand by experiments using a test battery cell of the same type as the subject battery cell.

Since the Weibull coefficients $m_f$, $\eta_f$, $m_c$ and $\eta_c$ are dependent on the capacity, structure, material, etc. of a battery cell, they differ according to the type of the battery cell. It is preferred, therefore, to use a test battery cell of the same type. If the same type of test battery cell is not used, the results of estimation of the state of health deviate from those of the storage battery system. Even the test battery cell of the same type gives results different according to an average charge rate (average SOC) representing its status of use. Thus, it is preferred to obtain the Weibull coefficients $m_f$, $\eta_f$ beforehand for each average SOC. Moreover, the Weibull coefficients $m_f$, $\eta_f$ also vary with the operating temperature, so that they should preferably be determined for each temperature. As will be described later, Weibull coefficients $m_c$, $\eta_c$ related to a cycle deterioration component are not dependent on the temperature.

The determination of the Weibull coefficients $m_f$, $\eta_f$, $m_c$ and $\eta_c$ by use of the test battery is made by calculations using calculation formulas for estimating the state of health s based on various tests.

From the temperature, current and voltage of the battery cell or the like acquired by the storage battery monitoring means 42, the average SOC of the battery in operation is determined. Weibull coefficients $m_f$, $\eta_f$, $m_c$, $\eta_c$ corresponding to the determined average SOC and the temperature are selected, and the state of health (SOH) of the battery cell or the like is estimated from the following estimation formula (A).

[Equation 7]

$$\text{Float capacity retention rate} = \exp\left\{-\left(\frac{t}{\eta_f}\right)^{m_f}\right\}\cdots(1)$$

$$\text{Cycle capacity retention rate} = \exp\left\{-\left(\frac{N}{\eta_c}\right)^{m_c}\right\}\cdots(2)$$

$$\text{State of health (SOH)} = \exp\left\{-\left(\frac{t}{\eta_f}\right)^{m_f}\right\}\times \exp\left\{-\left(\frac{N}{\eta_c}\right)^{m_c}\right\}\cdots(A)$$

A secondary battery state of health estimation method using the above-described estimation formula (A) for the state of health will be described in detail below.

The method of the present invention is predicated on a secondary battery state of health estimation method which estimates the state of health of a secondary battery based on the Weibull law by grasping the secondary battery as an assembly of partial batteries, and predicting the failure rate of the partial batteries. However, the inventive method is characterized in that the deterioration of the secondary battery, the cause of a decline in the state of health of the secondary battery, is separated into a float deterioration component and a cycle deterioration component, and the estimation formula (A) is worked out. By processing the temperature-dependent float capacity retention rate and the temperature-independent cycle capacity retention rate separately, a more accurate state of health can be estimated, and the state of health after long-term use, in particular, can be estimated more accurately, as will be described in more detail later. Hence, the effects of the present invention are great in judging the life of the secondary battery.

Here, the float capacity retention rate refers to deterioration dependent on the use period of the secondary battery, while the cycle capacity retention rate refers to deterioration dependent on a cycle number, with charge and discharge constituting one cycle.

A procedure for determining Weibull coefficients will be explained below.

(Float test for coefficient determination)

In regard to a secondary battery of a predetermined type, the secondary battery is operated at a predetermined temperature, the operation is fixed at predetermined SOC, and changes in the capacity during the operating time are measured. If necessary, the test is conducted similarly, with the state of a different operating temperature or different SOC being adopted. For example, the test is conducted for confirming capacity, with the voltage being fixed at SOC of 50%, and the test sample being left standing at each different temperature such as 25°C, 45°C or 60°C. Also, the test is conducted for confirming capacity, with SOC being fixed at a voltage having a different percentage, and the temperature being each of 25°C, 45°C and 60°C.

(Cycle test for coefficient determination)

For a secondary battery of a predetermined type, SOC is increased and decreased repeatedly, with the period of charging from SOC of 0% until SOC of 100% and discharging from SOC of 100% until SOC of 0% being counted as one cycle, and the duration of the cycle being constant. For example, if charges and discharges are performed, with the number of charges and discharges being set at 3/day, 3 cycles can be carried out in a day, 300 cycles in 100 days, and 3,000 cycles in 1,000 days.

Capacity corresponding to the period of time corresponding to the cycle number is measured, and the total cycle test capacity retention rate for determining Weibull coefficients is acquired.

The acquired measurement value is the capacity for each cycle number obtained when the secondary battery is operated at the predetermined temperature. It suffices that the number of cycles and the measurement value are in correspondence. The measurement may be made in each cycle, may be made at a predetermined number, or may be made irregularly. For a more accurate estimation of SOH, as many measurement values as possible are preferred.

The state of health is a value obtained by dividing the capacity after deterioration by the capacity at the beginning of the test, and is the proportion of the capacity after deterioration to the initial state of health. That is, the total cycle test capacity retention rate is a value obtained by dividing the measurement value, which has been acquired by the cycle test, by the initial full charge capacity.

(Method of actual value measurement for coefficient determination from secondary battery in operation)

The actual measurement value for coefficient determination may be directly obtained from the secondary battery as the subject for estimation of the state of health (SOH), for example, from the aforementioned storage battery system. In regard to a predetermined operating period from the start of operation, the capacity is measured when predetermined SOC is reached, whereby a measured value for float coefficient determination can be acquired. When a predetermined cycle number is reached from the start of operation, the capacity is measured, whereby a measured value for cycle coefficient determination can be acquired. How to count the cycle number for acquisition of the measured value for cycle coefficient determination can be decided as appropriate. For example, a set of charges and discharges by which the capacity changes by 50% or more of the full charge capacity may be counted as one cycle; whenever a specific SOC percentage is passed twice, one cycle may be counted; or in case the integrated actual charge/discharge capacity coincides with the capacity in one cycle of charge and discharge of the battery, one cycle may be counted. The battery temperature does not vary greatly depending on an environment where the storage battery system is disposed, so that the battery temperature can be measured, and the average temperature can be used.

The state of health is a value obtained by dividing the capacity after deterioration by the capacity at the beginning of the test, and is the proportion of the capacity after deterioration to the initial state of health. That is, the state of health is a value obtained by dividing the measurement value, which has been acquired from the storage battery system, by the initial full charge capacity.

The state of health of the storage battery system can be estimated if predetermined Weibull coefficients are determined by the following procedure:

(Method 1 for separation into float capacity retention rate and cycle capacity retention rate)

A cycle test is conducted using a secondary battery of a predetermined lot of secondary batteries of a predetermined type and, at the same time, a float test is conducted using the secondary battery of the same lot.

The state of health is found from the actually measured capacity, and subjected to Weibull plotting (ordinate ln(ln(1/retention rate)), abscissa 1n(period t)) to determine Weibull coefficients. Plotting on the ordinate ln(ln(1/retention rate)) and the abscissa 1n(period t) is also expressed as plotting the relation between the natural logarithm of the float period t, i.e. ln(t), and the natural logarithm of the reciprocal of the float measured value, i.e. ln(ln(1/float measured value)).

First of all, the relation between the period t of the float test and the retention rate is Weibull plotted to obtain a graph with ln(ln(1/retention rate)) on the ordinate and ln(period t) on the abscissa. The plot of this graph is subjected to a fitting technique such as regression analysis (e.g., least squares method) to obtain a linear prediction line (float deterioration prediction line), and mε and $\eta_f$ are determined from the slope and intercept of the prediction line. Concretely, the slope of the prediction line is mε, while $\eta_f$ is exp[intercept/(-$m_f$)]. Such a fitting technique can be carried out even with the use of simulation software or spreadsheet software.

As noted above, Weibull coefficients $m_f$, $\eta_f$ corresponding to the float capacity retention rate can be found from the results of the float test.

Fig. 4 is an example of Weibull plotting the results of the float test as described above. It shows the plot of the actual values measured at 25°C and SOC of 50%, 45°C and SOC of 50%, and 60°C and SOC of 50%. Under the respective conditions, the Weibull coefficients $m_f$, $\eta_f$ can be determined. From these Weibull coefficients $m_f$, $\eta_f$, the float capacity retention rate can be determined.

The Weibull coefficients under the different conditions are found to be different according to temperature. When the state of health of the storage battery in operation is to be found, it is preferred to use the results of the float test under temperature conditions close to the service temperature, the average temperature or the like.

On the other hand, the Weibull coefficients $m_c$, $\eta_c$ for the cycle capacity retention rate cannot be obtained from the results of the cycle test. In fact, the data on deterioration obtained from the cycle test include a component purely deteriorated by a cycle, and a component deteriorated by a float.

The following calculation is considered: capacity retention rate in cycle test = Retention rate in pure cycle deterioration × Retention rate in float deterioration (according to the Weibull law, the values to be totaled are multiplied to give a total value). Thus, a preferred calculation would be: Retention rate in pure cycle deterioration = capacity retention rate (measurement value) obtained from measured values in cycle test ÷ Float capacity retention rate (predicted value from the above float test under the Weibull law). Herein, this calculation is expressed as division-based return calculation.

Figs. 5(a) to 5(c) show an example of this division-based return calculation. (a) "Cycle total capacity retention rate (measurement value) obtained from measured values in cycle test" is divided by (b) "Float capacity retention rate (predicted value from the above float test under the Weibull law), with the period t being converted into the cycle number N, and plotting being performed". The resulting quotient is (c) "Cycle capacity retention rate which is the retention rate in pure cycle deterioration".

Fig. 5(c), as explained above, shows a plot of the results obtained by dividing the data on the actual values at 25°C, 45°C, 60°C in a return manner by the capacity retention rate obtained from the float test. The capacity retention rates (ordinates) representing the results of the cycle test at 25°C and SOC of 50%, 45°C and SOC of 50%, and 60°C and SOC of 50% are plotted for each cycle number.

The above division-based return calculation will be explained more concretely. During the execution of the cycle number N, float deterioration due to the float period t also occurs. For example, if the test involving 1,000 cycles results in the capacity retention rate of 85%, the float retention rate for the period t taken for the 1,000 cycles is found from the results of analysis of the results of the float test by the Weibull law. If the outcome (see, for example, Fig. 5(b)) is 90%, for example, the cycle retention rate due to pure cycle deterioration in the 1,000 cycles is 85% divided by 90%, equaling 94.4%, which turns out to be the cycle capacity retention rate (Fig. 5(c)).

Using such a cycle capacity retention rate corresponding to the pure cycle deterioration component, Weibull plotting (ln(ln(1/retention rate)) on the ordinate and ln(period t) on the abscissa) is performed to determine Weibull coefficients similarly to the float test. That is, a prediction line is obtained by a fitting technique such as the least squares method, similarly to the float test, starting with the Weibull plot. From the slope and intercept of the prediction line, $m_c$, $\eta_c$ are determined. From these Weibull coefficients $m_c$, $\eta_c$, the cycle capacity retention rate can be determined.

(Method 2 for separation into float capacity retention rate and cycle capacity retention rate)

A cycle test is conducted using a secondary battery of a predetermined lot of secondary batteries of a predetermined type.

From the capacity obtained from the actually measured values of this test, a cycle total capacity retention rate is determined. It is Weibull plotted in relation to the period t (ordinate ln(ln(1/total capacity retention rate)), abscissa 1n(period t)). An example of the results obtained is shown in Fig. 6.

Then, the points on the plot are subjected to polynomial fitting to obtain a formula representing a curve. The polynomial formula is differentiated to find the slope of a tangent to the formula. In finding the slope of the tangent, it is preferred, if possible, to find the slope during an initial period of the Weibull plot. A zone up to the fifth point on the plot is preferred, because it is minimally affected by cycle deterioration. A zone up to the third point on the plot is more preferable, and it is even more preferable to find the tangent at the first point on the plot. This is because finding the tangent in a shorter period can eliminate the influence of the cycle deterioration. Fig. 7 shows an example of these results.

Moreover, an initial period of the Weibull plot enables the slope of a straight line between two points on the Weibull plot to be used as the slope of the tangent in finding the slope. In this case as well, the influence of the cycle deterioration can be eliminated, so that it is preferred to find the tangent in a shorter period. Furthermore, the two points on the Weibull plot, which are used to find the slope, are preferably those on the plot in a continuous cycle number.

This slope is taken as the slope of a prediction line of the float capacity retention rate. A straight-line equation, which serves as a tangent at the first point on the curve, is determined, and this straight-line equation is taken as a prediction line of the float deterioration component. From the slope and intercept of the prediction line, Weibull coefficients $m_f$, $\eta_f$ are determined. Fig. 8 is an example of these results.

Then, the total capacity retention rate is subjected to division-based return calculation using the prediction line of the float capacity retention rate to obtain a cycle capacity retention rate. Using this rate, a Weibull plot is prepared in relation to the cycle number N. Fig. 9 shows an example of these results.

Then, from the Weibull pot of the cycle deterioration component, a prediction line is found by a fitting technique such as the least squares method, as in the aforementioned example. From the slope and intercept of the prediction line, $m_c$, $\eta_c$ are determined. Fig. 10 shows an example of these results.

In the foregoing manner, the state of health can be obtained as in the aforementioned Method 1 for separation.

(Method 3 for separation into float capacity retention rate and cycle capacity retention rate)

Data on the battery in actual operation are acquired from a site where the data are stored.

From the capacity obtained from the actually measured values of the battery in operation, a measured total capacity retention rate is determined. It is Weibull plotted in relation to the period t (ordinate ln(ln(1/total capacity retention rate)), abscissa 1n(period t)).

Then, the points on the plot are subjected to polynomial fitting to obtain a formula representing a curve. The polynomial formula is differentiated to find the slope of a tangent to the formula. In finding the slope of the tangent, it is preferred, if possible, to find the slope during an initial period of the Weibull plot. A zone up to the fifth point on the plot is preferred, because it is minimally affected by cycle deterioration. A zone up to the third point on the plot is more preferable, and it is even more preferable to find the tangent at the first point on the plot. This is because finding the tangent in a shorter period can eliminate the influence of the cycle deterioration.

Moreover, an initial period of the Weibull plot enables the slope of a straight line between two points on the Weibull plot to be used as the slope of the tangent in finding the slope. In this case as well, the influence of the cycle deterioration can be eliminated, so that it is preferred to find the tangent in a shorter period. Furthermore, the two points on the Weibull plot, which are used to find the slope, are preferably those on the plot involving a continuous cycle number.

This slope is taken as the slope of a prediction line of the float capacity retention rate. A straight-line equation, which becomes a tangent at the first point on the curve, is determined, and this straight-line equation is taken as a prediction line of the float deterioration component. From the slope and intercept of the prediction line, Weibull coefficients $m_f$, $\eta_f$ are determined.

Then, the total capacity retention rate is subjected to division-based return calculation using the prediction line of the float capacity retention rate to obtain a cycle capacity retention rate. Using this rate, a Weibull plot is prepared in relation to the cycle number N. Then, from the Weibull pot of the cycle deterioration component, a prediction line is found by a fitting technique such as the least squares method, as in the aforementioned example. From the slope and intercept of the prediction line, $m_c$, $\eta_c$ are determined. In the foregoing manner, the state of health can be obtained as in the aforementioned Methods 1 and 2 for separation.

(Estimation of state of health)

In regard to a secondary battery of the same type as the type of the subject for estimation, Weibull coefficients $m_f$, $\eta_f$, $m_c$, and $\eta_c$ corresponding to a predetermined temperature and predetermined SOC are selected. They are introduced into the aforementioned estimation formula (A) to estimate the state of health (SOH) during the period t.

By estimating a future state of health (SOH) more accurately, parameters for charge/discharge of a secondary battery used for a long period until being deteriorated can be properly set. Thus, the battery can be prevented from overcharge and overdischarge, and can be used more safely. Also, the remaining power of the storage battery system can be detected, and the timings of maintenance, replacement of the battery, etc. can be grasped more accurately.

[Examples]

(Example 1)

For a lithium ion secondary battery, the above-mentioned method for separation into the float deterioration component and the cycle deterioration component was used to find Weibull coefficients.

Secondary battery (PD50S03): Composed of lithium iron phosphate as a positive electrode, graphite as a negative electrode, and ethylene carbonate (EC):dimethyl carbonate (DMC) = 3:7 as an electrolyte solution with 1.2M of lithium hexafluorophosphate ($LiPF_6$) being inserted as a supporting electrolyte. The positive electrode and the negative electrode were laminated elements, and disposed face-to-face, with a polyolefin separator interposed therebetween. Had a capacity of 50 Ah. The elements were housed in an SUS metal case.

A cycle test involved six cycles per day.

A float test was conducted at an average SOC of 75% and a temperature of 30°C.

Method 1 for separation described above was used to determine Weibull coefficients. The Weibull coefficients were as follows:

$$m_f \text{ (m of float capacity retention rate)} = 0.289298$$

$$\eta_f \text{ (}\eta\text{ of float capacity retention rate)} = 7.14\times10^3 \text{ (period: year)}$$

$$m_c \text{ (m of cycle capacity retention rate)} = 1.86356$$

$$\eta_c \text{ (}\eta\text{ of cycle capacity retention rate)} = 40751.6$$

The results were a deterioration line as shown in Fig. 11.

(Example 2)

Using the same secondary battery as that in Example 1 and the above-mentioned Method 1 for separation into the float deterioration component and the cycle deterioration component, the state of health was determined.

Fig. 12 shows the state of health s at 60°C and each SOC.

(Example 3)

Using the same secondary battery as that in Example 1 and the above-mentioned Method 1 for separation into the float deterioration component and the cycle deterioration component, the state of health was determined.

Fig. 13 shows the state of health at 25°C and each SOC.

(Examples 1 to 3)

Based on Figs. 11 to 13 showing the results of Examples 1 to 3 obtained by Method 1 for separation, the predicted values and the measured values coincided closely in any of the cases.

Fig. 14 shows a comparison between the predicted values and the measured values in the long cycle period of Example 1.

Predictions were made at the average SOC of 70% and at 30°C in 6 cycles per day.

The predicted values and the measured values nearly coincided.

In connection with Example 2, the predicted values obtained from long-term predictions and the measured values were compared. The results are shown in Fig. 15.

As a result, the predicted values and the measured value were coincident even at a cycle number close to 15,000 cycles.

For comparison, predictions were made by the Weibull law (Comparative Example 1) and by the conventional exponential law (Comparative Example 2), without separation into the float deterioration component and the cycle deterioration component. Plots of the results showed that deviations from the measured values increased at a cycle number of 11,000 cycles or more.

(Example 4)

Using the same secondary battery as that in Example 1 and the above-mentioned Method 2 for separation into the float deterioration component and the cycle deterioration component, the state of health was determined.

The results are shown in Fig. 16. Float deterioration predictions multiplied by cycle deterioration predictions were the results of Example 4. The predicted values and the measured values were almost in correspondence. For comparison, only float deterioration predictions and only cycle deterioration predictions were revealed. However, they were greatly different from the measured values.

(Example 5)

Using data acquired from a system (battery capacity 2.5 kWh) composed of 16 of the same secondary batteries as those in Example 1 which were connected in series, and using the above-mentioned Method 3 for separation into the float deterioration component and the cycle deterioration component, the state of health was determined.
The results are shown in Fig. 17. The predicted values and the measured values nearly coincided.

[Industrial Applicability]

The present invention can be utilized effectively in an industrial field where a storage battery system using a storage battery as a power supply, and in an industrial field where maintenance and operation of such a storage battery system are performed.

[Explanations of Letters or Numerals]

| | |
|---|---|
| 1 | Storage battery system |
| 2 | Storage battery |
| 2a | Secondary battery cell |
| 3 | Power regulator |
| 4 | Commercial power source |
| 5 | Load |
| 6 | Solar power generation device (power generator) |
| 30 | Inverter |
| 31 | First switch |
| 32 | Second switch |
| 33 | Third switch |
| 34 | Fourth switch |
| 35 | Fifth switch |
| 40 | Control unit |
| 41 | Power generator monitoring means |
| 42 | Storage battery monitoring means |
| 43 | Charge/discharge control means |

## Claims

**1.** A secondary battery state of health estimation method, which estimates a state of health (SOH) of a secondary battery by use of a Weibull law, comprising:

separating a total capacity retention rate of the secondary battery, obtained from at least one of data on the secondary battery in operation and a cycle test, into a float capacity retention rate ascribed to deterioration dependent on a use period, and a cycle capacity retention rate ascribed to deterioration dependent on a number of charges/discharges;
obtaining Weibull coefficients $m_f$, $\eta_f$ corresponding to the float capacity retention rate, and the float capacity retention rate represented by the following formula (1);
obtaining Weibull coefficients $m_c$, $\eta_c$ corresponding to the cycle capacity retention rate, and the cycle capacity retention rate represented by the following formula (2); and
estimating the state of health in a period t or at a cycle number N from the following formula (A):

[Equation 1]

$$\text{Float capacity retention rate} = \exp\left\{-\left(\frac{t}{\eta_f}\right)^{m_f}\right\} \cdots (1)$$

$$\text{Cycle capacity retention rate} = \exp\left\{-\left(\frac{N}{\eta_c}\right)^{m_c}\right\} \cdots (2)$$

$$\text{State of health (SOH)} = \exp\left\{-\left(\frac{t}{\eta_f}\right)^{m_f}\right\} \times \exp\left\{-\left(\frac{N}{\eta_c}\right)^{m_c}\right\} \cdots (A)$$

**2.** The secondary battery state of health estimation method according to Claim 1, comprising:
obtaining the float capacity retention rate from measurement values of a float test; and separating a measured total capacity retention rate obtained from the data on the secondary battery in operation, or a total cycle test capacity retention rate obtained from measurement values of the cycle test, as the total capacity retention rate, into the float capacity retention rate and the cycle capacity retention rate.

**3.** The secondary battery state of health estimation method according to Claim 2, comprising:

Weibull plotting the float capacity retention rate in relation to ln(period) and ln(ln(1/ capacity retention rate)) to prepare a Weibull plot of the float capacity retention rate;
estimating a float deterioration prediction line, represented by a straight-line equation, from the Weibull plot of the float capacity retention rate;
obtaining mε and $\eta_f$ from a slope and an intercept of the float deterioration prediction line;
determining the float capacity retention rate from the mε and $\eta_f$ and the formula (1);
dividing the total capacity retention rate by the float capacity retention rate to calculate the cycle capacity retention rate;
Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

**4.** The secondary battery state of health estimation method according to Claim 1, comprising:
obtaining the float capacity retention rate from measurement values of the cycle test; and separating a measured total capacity retention rate obtained from the data on the secondary battery in operation, or a total cycle test capacity retention rate obtained from the measurement values of the cycle test, as the total capacity retention rate, into the float capacity retention rate and the cycle capacity retention rate.

**5.** The secondary battery state of health estimation method according to Claim 4, comprising:

Weibull plotting the total capacity retention rate in relation to ln(period) and ln(ln(1/ capacity retention rate)) to prepare a Weibull plot of the total capacity retention rate;
polynomial fitting the Weibull plot of the total capacity retention rate to find a polynomial representing a curve;
finding a tangent to the polynomial during an initial predetermined period;
obtaining mε and $\eta_f$ from a slope and an intercept of the tangent;
determining the float capacity retention rate from the $m_f$ and $\eta_f$ and the formula (1);
dividing the total capacity retention rate by the float capacity retention rate to calculate the cycle capacity retention rate;
Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

6. The secondary battery state of health estimation method according to Claim 4, comprising:

Weibull plotting the total capacity retention rate in relation to ln(period) and ln(ln(1/ capacity retention rate)) to prepare a Weibull plot of the total capacity retention rate;
polynomial fitting the Weibull plot of the total capacity retention rate to find a polynomial representing a curve;
finding a slope from two points on the Weibull plot during an initial predetermined period in the polynomial;
finding a tangent to the polynomial having the slope;
obtaining $m_f$ and $\eta_f$ from a slope and an intercept of the tangent;
determining the float capacity retention rate from the mε and $\eta_f$ and the formula (1);
dividing the total capacity retention rate by the float capacity retention rate to calculate the cycle capacity retention rate;
Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

7. The secondary battery state of health estimation method according to Claim 1, comprising:
determining the float capacity retention rate from a measured total capacity retention rate obtained from the data on the secondary battery in operation; and separating the measured total capacity retention rate obtained from the data on the secondary battery in operation, or a total cycle test capacity retention rate obtained from measurement values of the cycle test, as the total capacity retention rate, into the float capacity retention rate and the cycle capacity retention rate.

8. The secondary battery state of health estimation method according to Claim 7, comprising:

Weibull plotting the measured total capacity retention rate in relation to ln(period) and ln(ln(1/ capacity retention rate)) to prepare a Weibull plot of the measured total capacity retention rate;
polynomial fitting the Weibull plot of the measured total capacity retention rate to find a polynomial representing a curve;
finding a tangent to the polynomial during an initial predetermined period;
obtaining mε and $\eta_f$ from a slope and an intercept of the tangent;
determining the float capacity retention rate from the mε and $\eta_f$ and the formula (1);
dividing the total capacity retention rate by the float capacity retention rate to calculate the cycle capacity retention rate;
Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

9. The secondary battery state of health estimation method according to Claim 7, comprising:

Weibull plotting the measured total capacity retention rate in relation to ln(period) and ln(ln(1/ capacity retention rate)) to prepare a Weibull plot of the measured total capacity retention rate;
polynomial fitting the Weibull plot of the measured total capacity retention rate to find a polynomial representing a curve;
finding a slope from two points on the Weibull plot during an initial predetermined period in the polynomial;
finding a tangent to the polynomial having the slope;
obtaining mε and $\eta_f$ from a slope and an intercept of the tangent;
determining the float capacity retention rate from the mε and $\eta_f$ and the formula (1);
dividing the total capacity retention rate by the float capacity retention rate to calculate the cycle capacity retention rate;
Weibull plotting the cycle capacity retention rate in relation to ln(cycle number) and ln(ln(1/ capacity retention rate)) to prepare a Weibull plot of the cycle capacity retention rate;
estimating a cycle deterioration prediction line, represented by a straight-line equation, from the Weibull plot of the cycle capacity retention rate;
obtaining $m_c$ and $\eta_c$ from a slope and an intercept of the cycle deterioration prediction line; and
determining the cycle capacity retention rate from the $m_c$ and $\eta_c$ and the formula (2).

**10.** A secondary battery state of health estimation program, which estimates a state of health (SOH) of a secondary battery by use of a Weibull law,
the program comprising making a computer work to perform:

a step of separating a total capacity retention rate of the secondary battery, obtained from at least one of data on the secondary battery in operation, a cycle test, and a float test, into a float capacity retention rate ascribed to deterioration dependent on a use period, and a cycle capacity retention rate ascribed to deterioration dependent on a number of charges/discharges;
a step of obtaining Weibull coefficients $m_f$, $\eta_f$ corresponding to the float capacity retention rate, and the float capacity retention rate represented by the following formula (1);
a step of obtaining Weibull coefficients $m_c$, $\eta_c$ corresponding to the cycle capacity retention rate, and the cycle capacity retention rate represented by the following formula (2); and
a step of estimating the state of health in a period t or at a cycle number N from the following formula (A):

[Equation 2]

$$\text{Float capacity retention rate} = \exp\left\{-\left(\frac{t}{\eta_f}\right)^{m_f}\right\} \cdots (1)$$

$$\text{Cycle capacity retention rate} = \exp\left\{-\left(\frac{N}{\eta_c}\right)^{m_c}\right\} \cdots (2)$$

$$\text{State of health (SOH)} = \exp\left\{-\left(\frac{t}{\eta_f}\right)^{m_f}\right\} \times \exp\left\{-\left(\frac{N}{\eta_c}\right)^{m_c}\right\} \cdots (A)$$

**11.** A secondary battery state of health estimation apparatus, which performs a secondary battery state of health estimation method to estimate a state of health (SOH) of a secondary battery,
the apparatus comprising:

storage means storing data on at least one of a cycle test and a float test; and
data acquisition means for acquiring data on the secondary battery in operation, a period t, and a cycle number N from the secondary battery;
the apparatus executing
a step of separating a total capacity retention rate of the secondary battery, obtained from at least one of data on the secondary battery in operation and a cycle test, into a float capacity retention rate ascribed to deterioration dependent on a use period, and a cycle capacity retention rate ascribed to deterioration dependent on a number of charges/discharges;
a step of obtaining Weibull coefficients $m_f$, $\eta_f$ corresponding to the float capacity retention rate, and the float capacity retention rate represented by the following formula (1);
a step of obtaining Weibull coefficients $m_c$, $\eta_c$ corresponding to the cycle capacity retention rate, and the cycle capacity retention rate represented by the following formula (2); and
a step of estimating the state of health in the period t or at the cycle number N from the following formula (A):

[Equation 3]

$$\text{Float capacity retention rate} = \exp\left\{-\left(\frac{t}{\eta_f}\right)^{m_f}\right\} \cdots (1)$$

$$\text{Cycle capacity retention rate} = \exp\left\{-\left(\frac{N}{\eta_c}\right)^{m_c}\right\} \cdots (2)$$

$$\text{State of health (SOH)} = \exp\left\{-\left(\frac{t}{\eta_f}\right)^{m_f}\right\} \times \exp\left\{-\left(\frac{N}{\eta_c}\right)^{m_c}\right\} \cdots (A)$$

Fig. 1

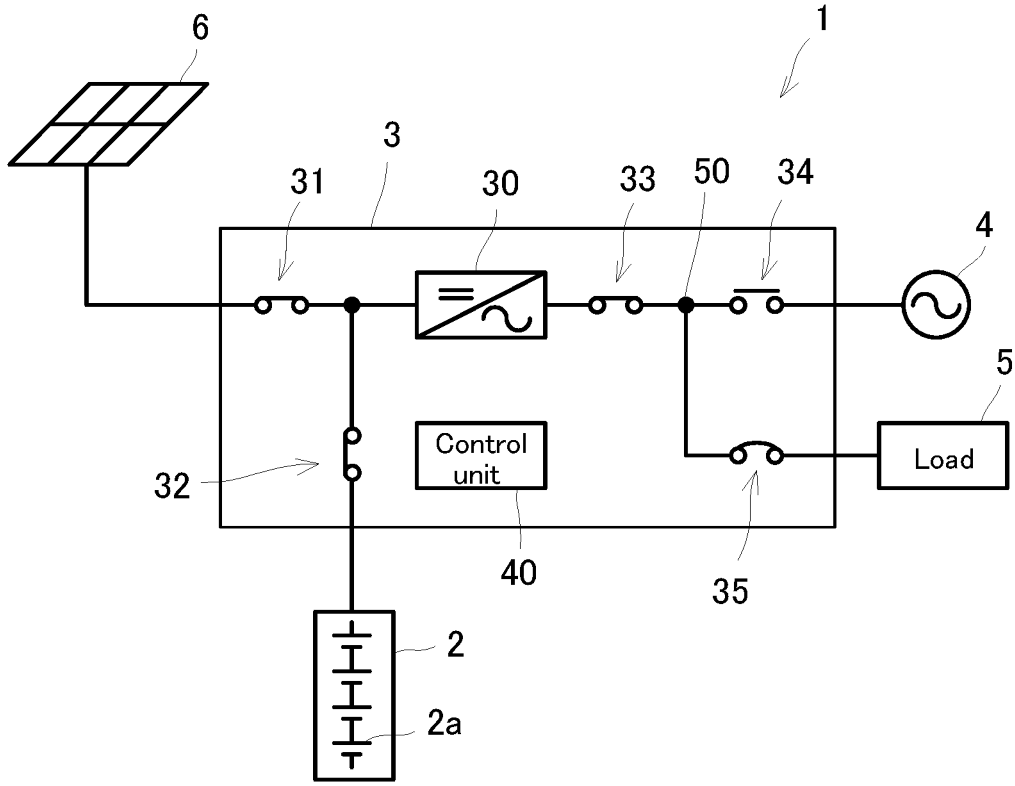

Fig. 2

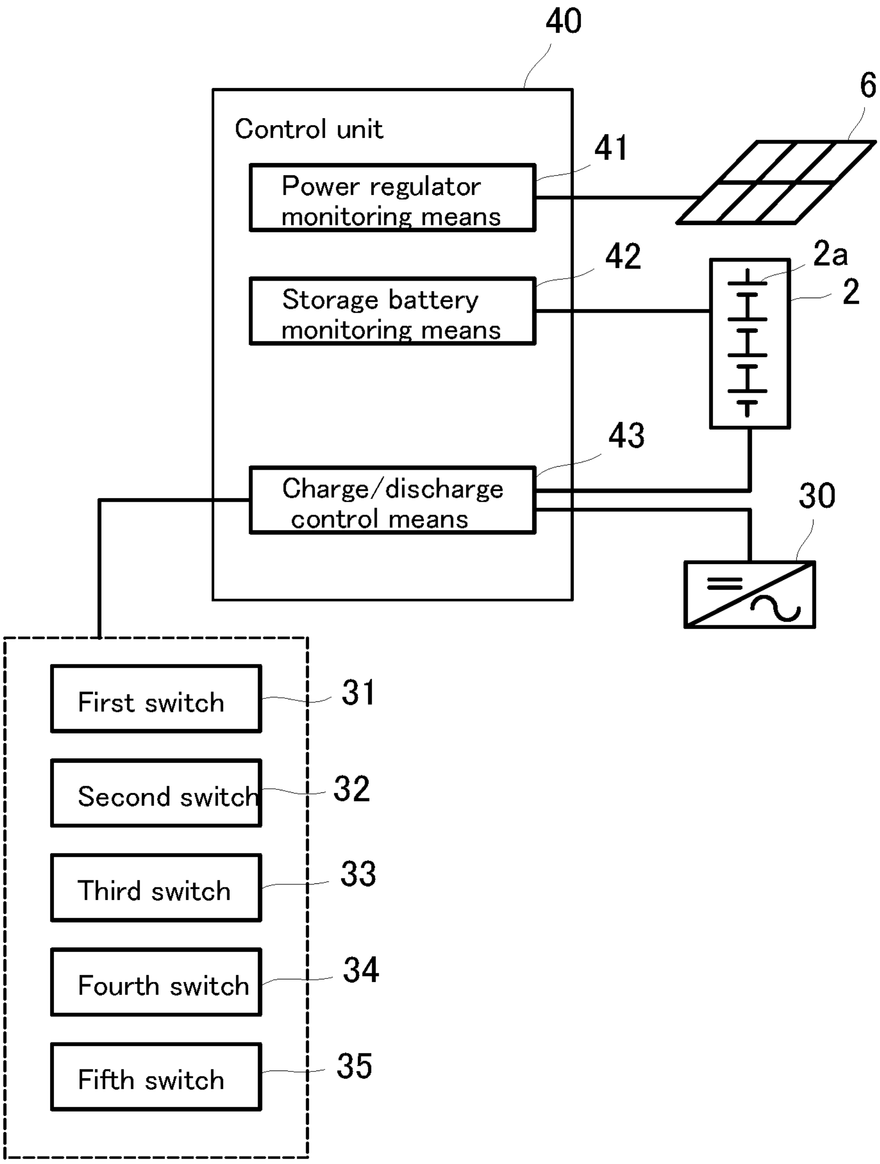
40
Control unit
41
Power regulator monitoring means
6
42
Storage battery monitoring means
2a
2
43
Charge/discharge control means
30
First switch
31
Second switch
32
Third switch
33
Fourth switch
34
Fifth switch
35

Fig. 3

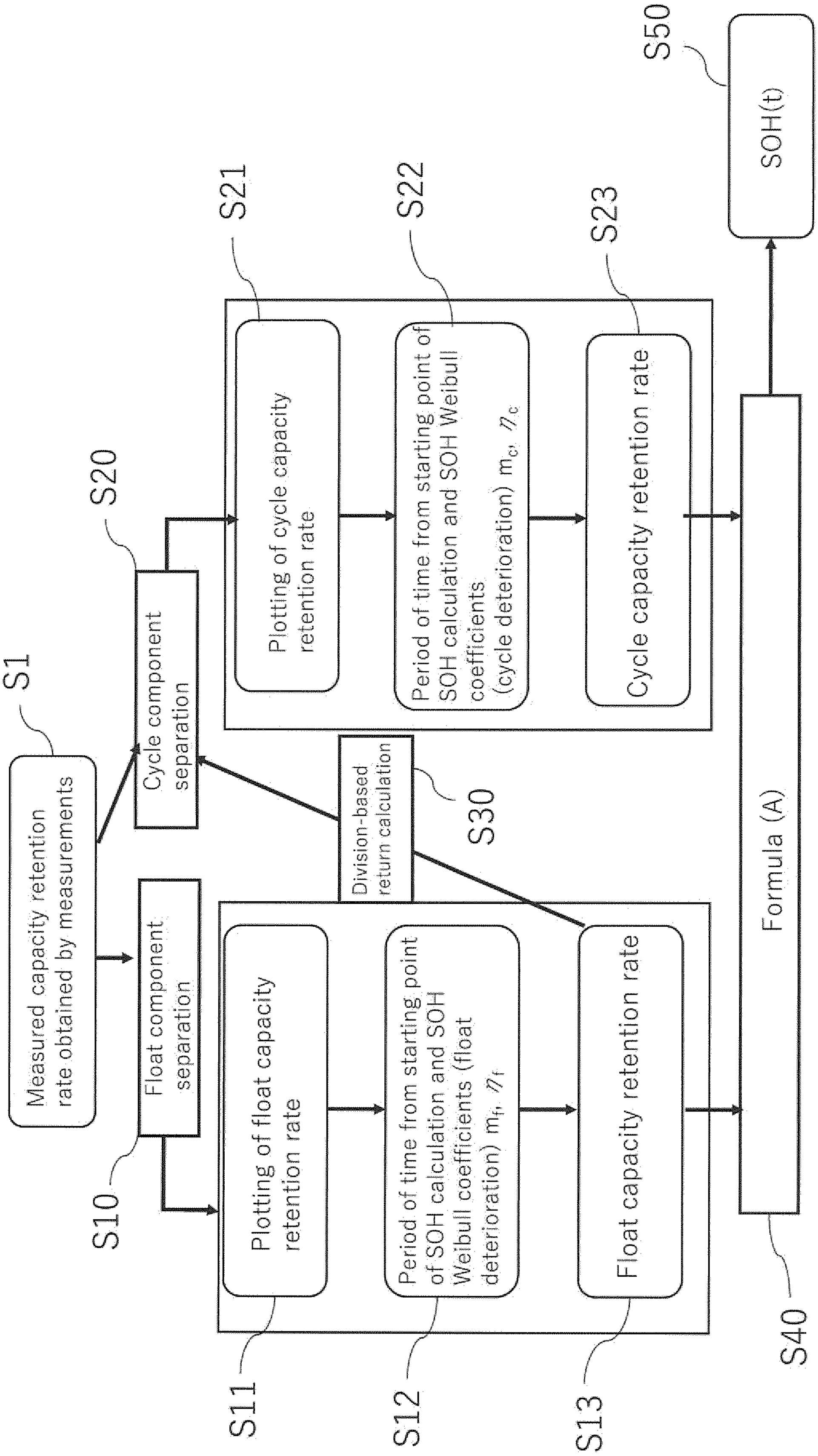
S1
Measured capacity retention rate obtained by measurements
S10
Float component separation
S20
Cycle component separation
S11
Plotting of float capacity retention rate
S12
Period of time from starting point of SOH calculation and SOH Weibull coefficients (float deterioration) $m_f$, $\eta_f$
S13
Float capacity retention rate
S21
Plotting of cycle capacity retention rate
S22
Period of time from starting point of SOH calculation and SOH Weibull coefficients (cycle deterioration) $m_c$, $\eta_c$
S23
Cycle capacity retention rate
S30
Division-based return calculation
S40
Formula (A)
S50
SOH(t)

Fig. 4

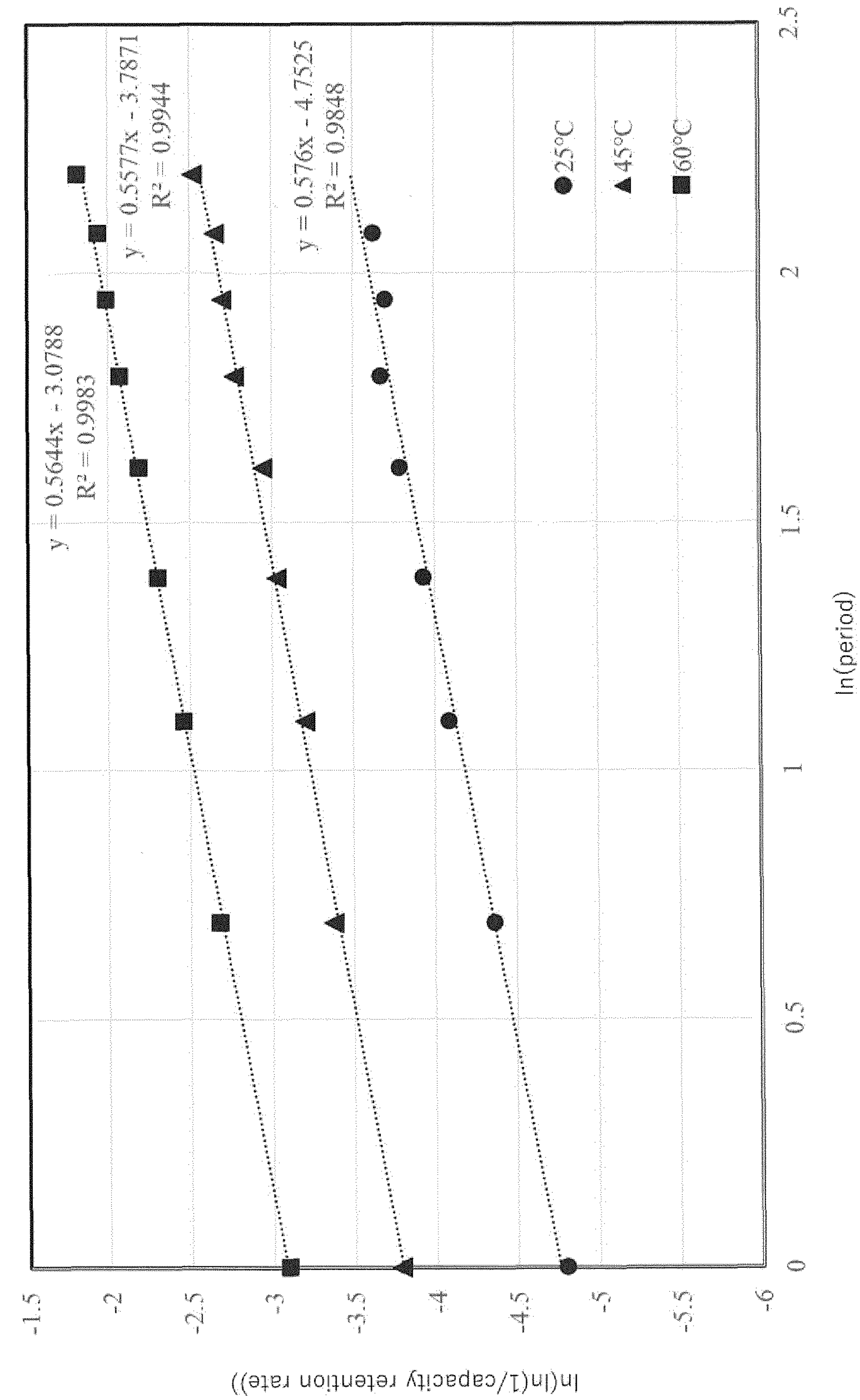
y = 0.5644x - 3.0788
R² = 0.9983
y = 0.5577x - 3.7871
R² = 0.9944
y = 0.576x - 4.7525
R² = 0.9848
25°C
45°C
60°C
ln(ln(1/capacity retention rate))
ln(period)
-1.5
-2
-2.5
-3
-3.5
-4
-4.5
-5
-5.5
-6
0
0.5
1
1.5
2
2.5

Fig. 5

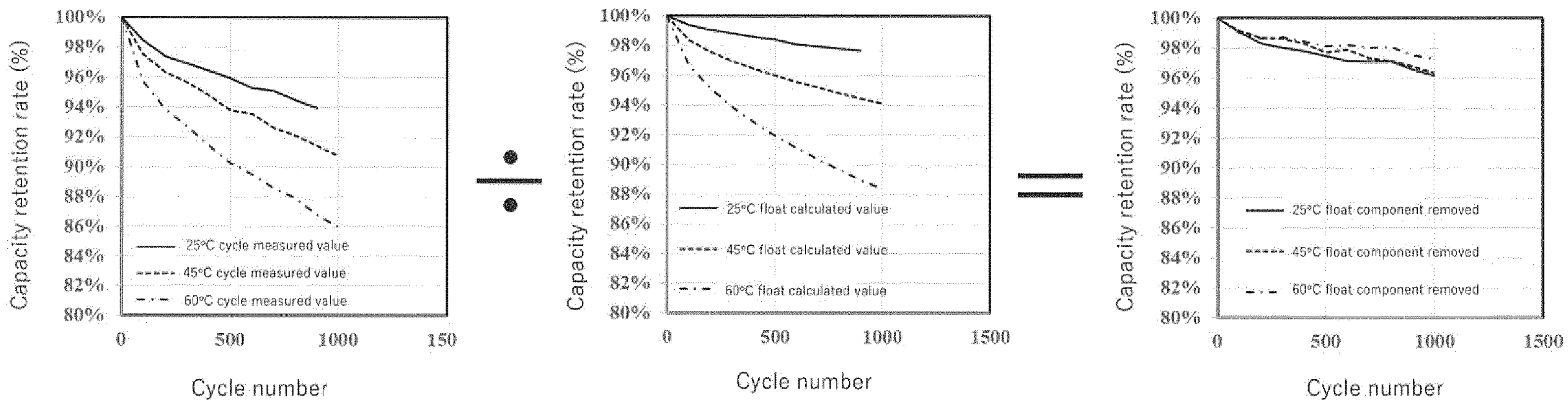


(a)
Cycle total capacity retention rate

(b)
Float capacity retention rate (plotted, period t converted to cycle number N)

(c)
Cycle capacity retention rate

Fig. 6

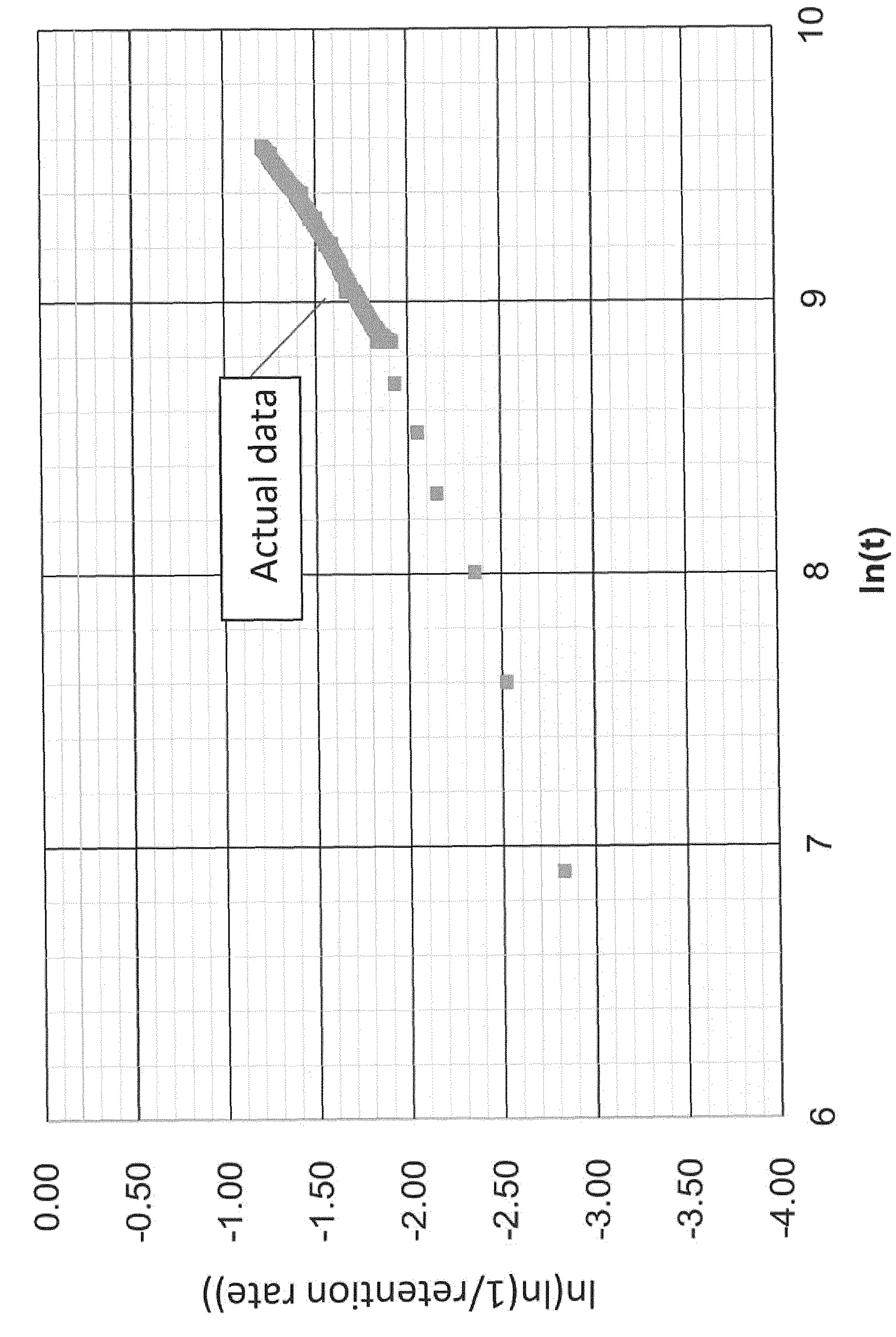

Actual data
ln(t)
6
7
8
9
10
ln(ln(1/retention rate))
0.00
-0.50
-1.00
-1.50
-2.00
-2.50
-3.00
-3.50
-4.00

Fig. 7

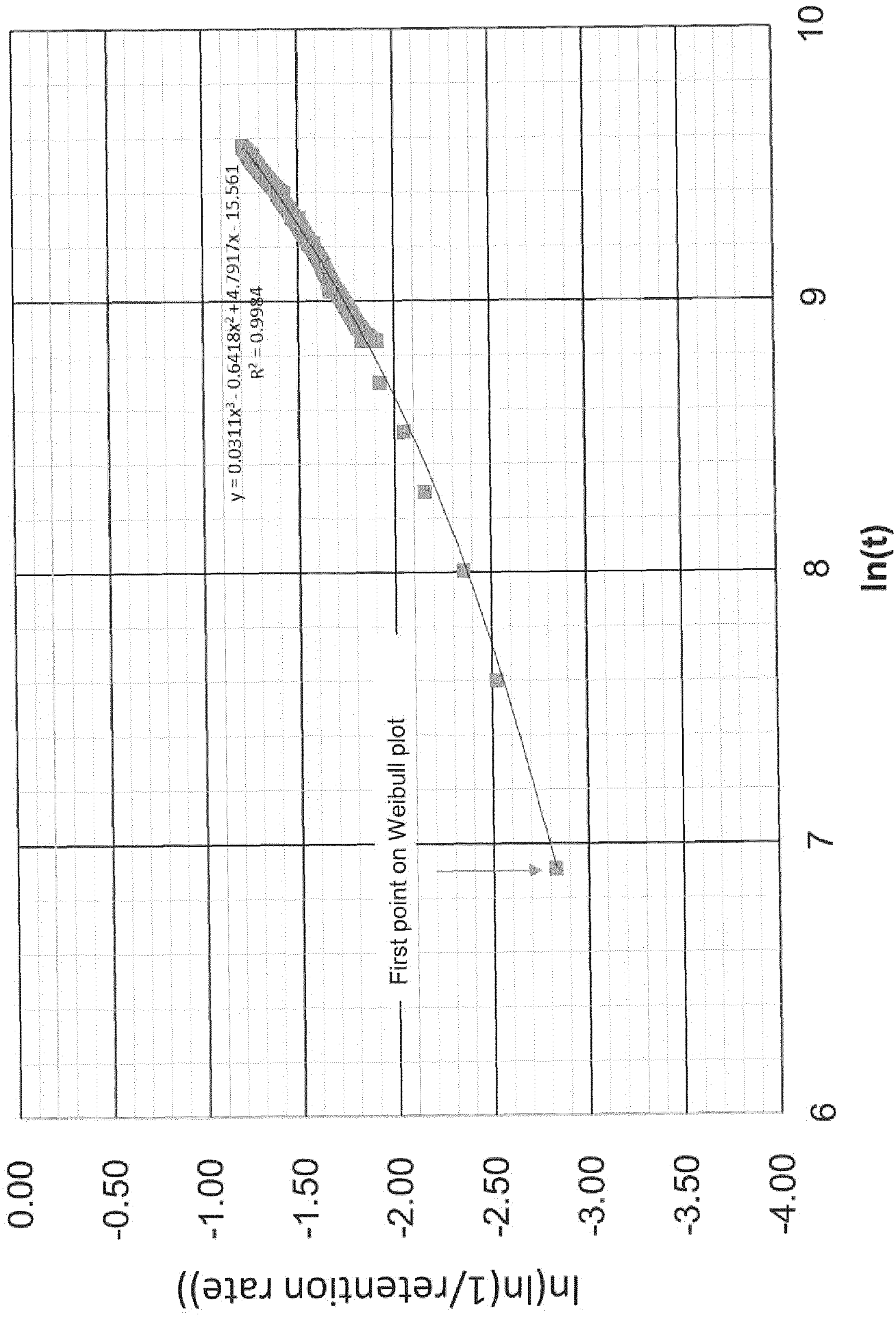

y = 0.0311x³ - 0.6418x² + 4.7917x - 15.561
R² = 0.9984
First point on Weibull plot
ln(ln(1/retention rate))
0.00
-0.50
-1.00
-1.50
-2.00
-2.50
-3.00
-3.50
-4.00
6
7
8
9
10
ln(t)

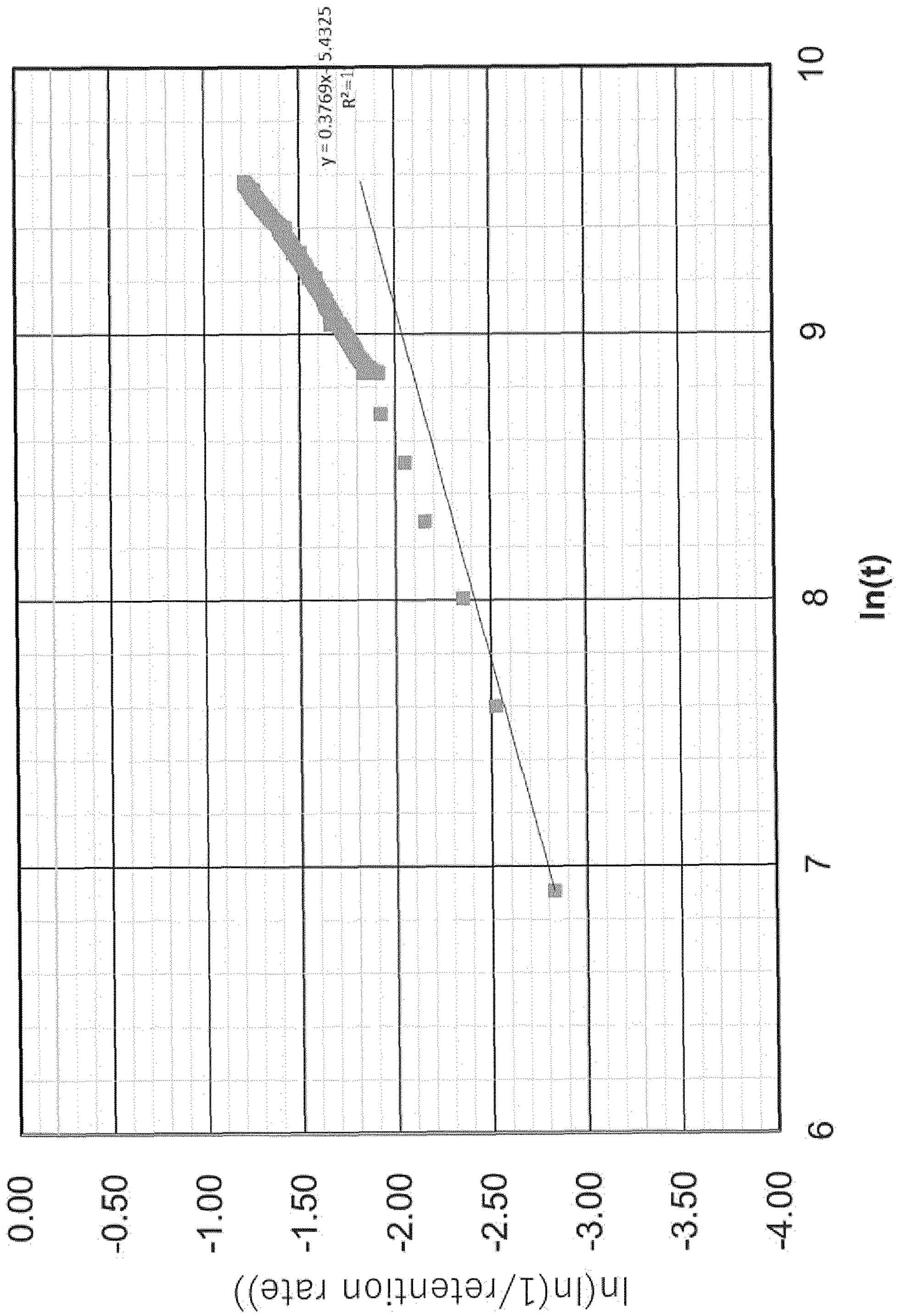
y = 0.3769x - 5.4325
R² = 1
0.00
-0.50
-1.00
-1.50
-2.00
-2.50
-3.00
-3.50
-4.00
ln(ln(1/retention rate))
6
7
8
9
10
ln(t)

Fig. 8

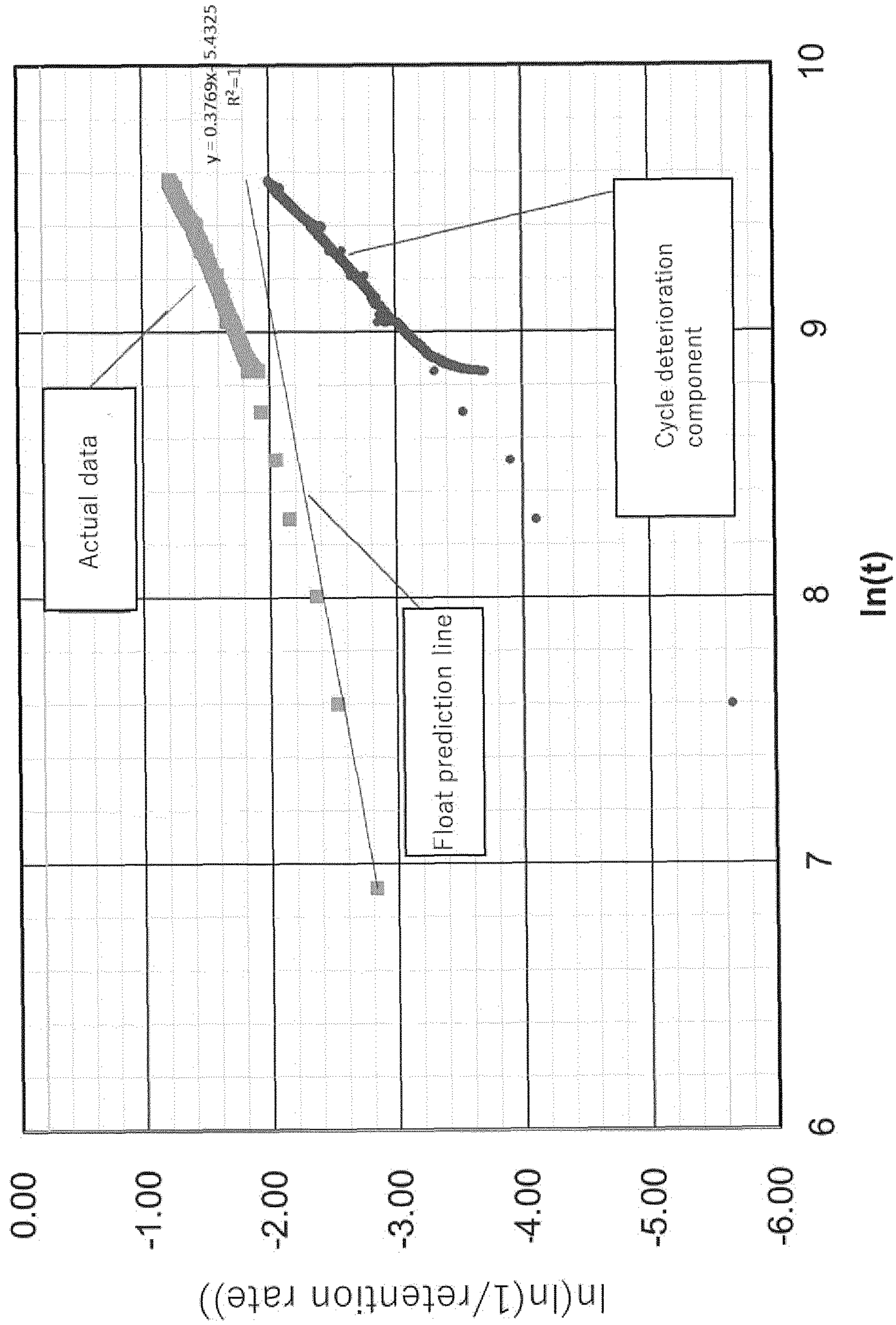
y = 0.3769x - 5.4325
R² = 1
Actual data
Float prediction line
Cycle deterioration component
0.00
-1.00
-2.00
-3.00
-4.00
-5.00
-6.00
ln(ln(1/retention rate))
6
7
8
9
10
ln(t)

Fig. 9

Fig. 10

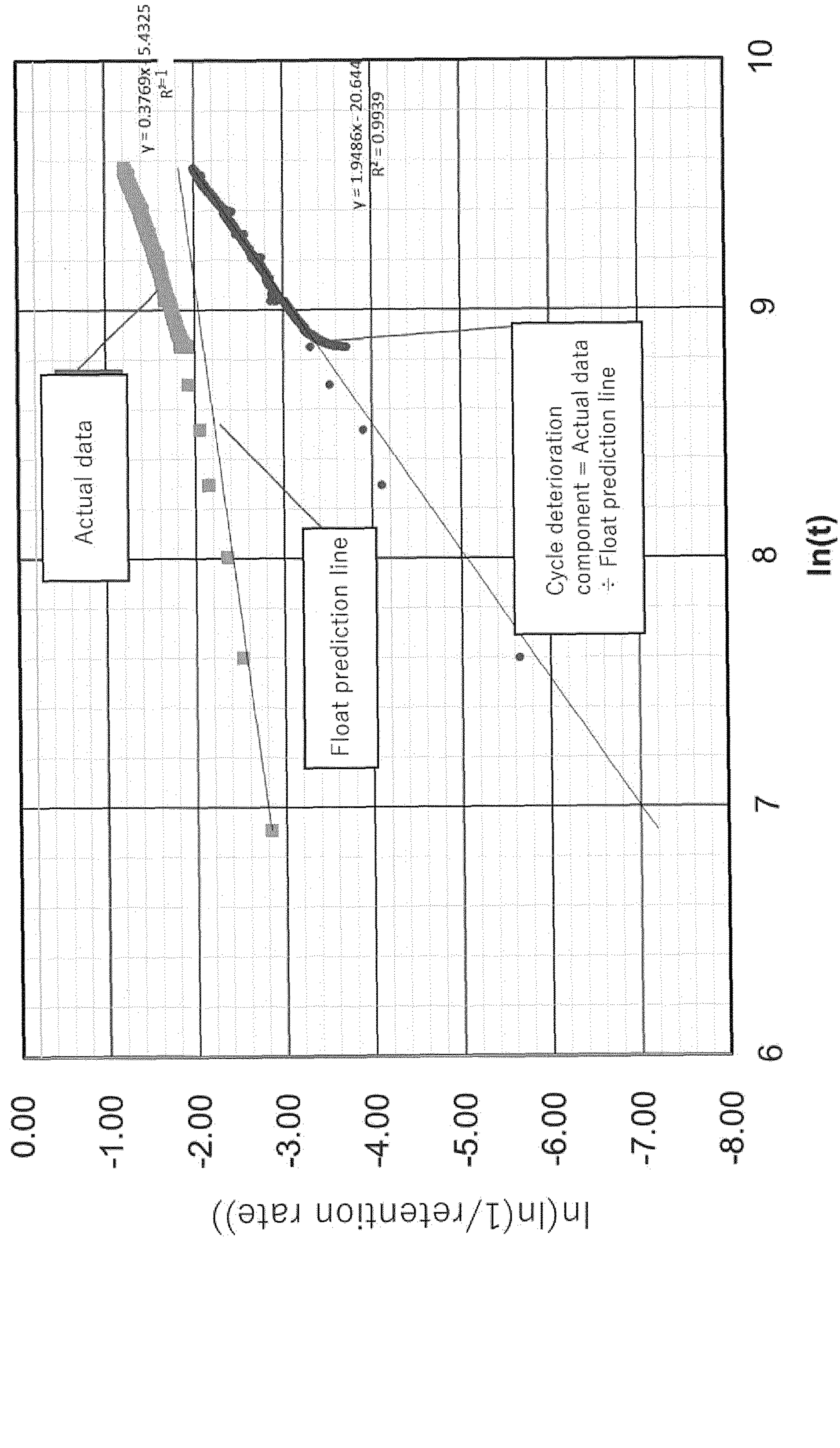

y = 0.3769x - 5.4325
R² = 1
y = 1.9486x - 20.644
R² = 0.9939
Actual data
Float prediction line
Cycle deterioration component = Actual data ÷ Float prediction line
0.00
-1.00
-2.00
-3.00
-4.00
-5.00
-6.00
-7.00
-8.00
ln(ln(1/retention rate))
6
7
8
9
10
ln(t)

Fig. 11

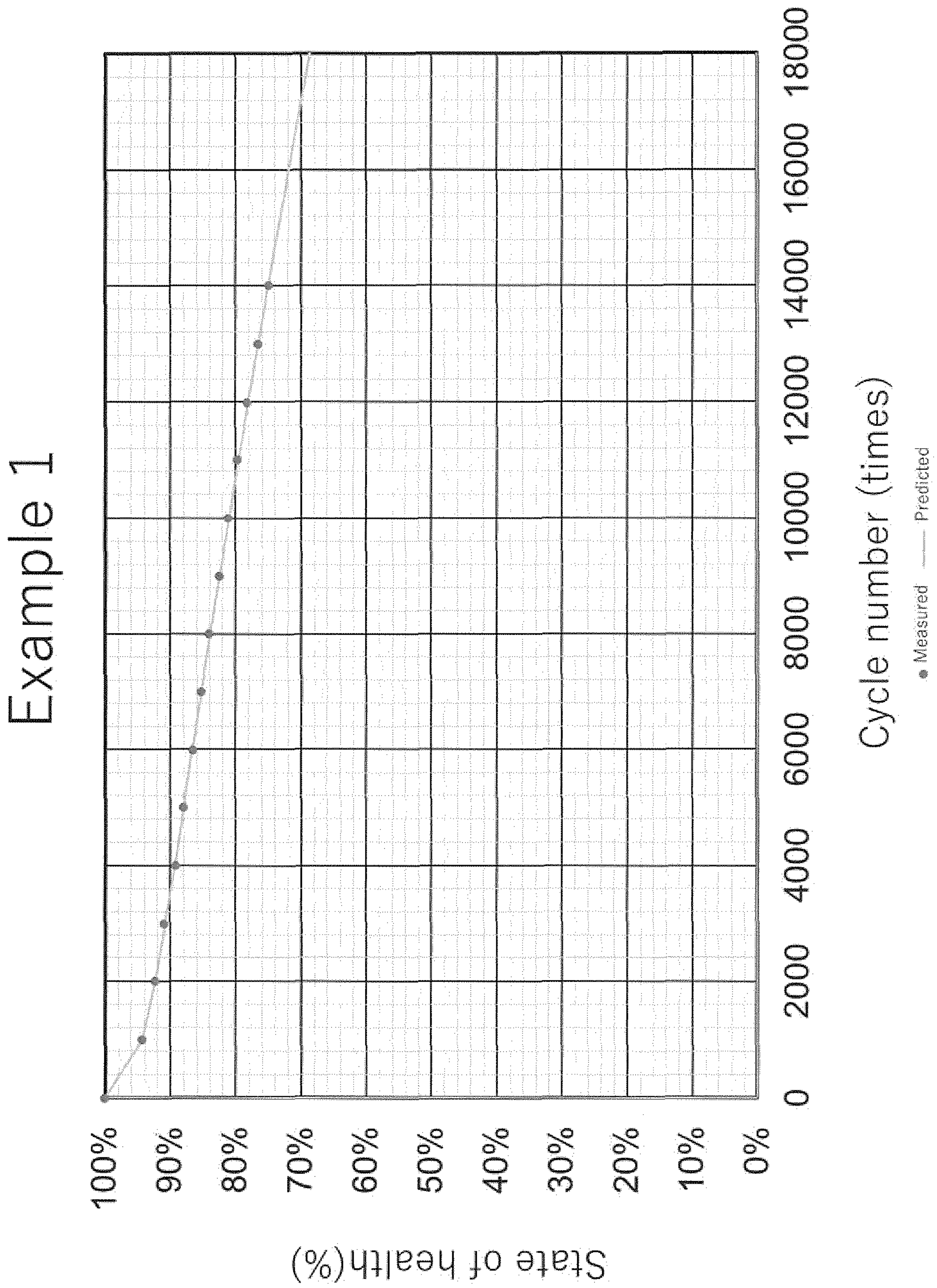
Example 1
State of health(%)
100%
90%
80%
70%
60%
50%
40%
30%
20%
10%
0%
0
2000
4000
6000
8000
10000
12000
14000
16000
18000
Cycle number (times)
Measured
Predicted

Fig. 12

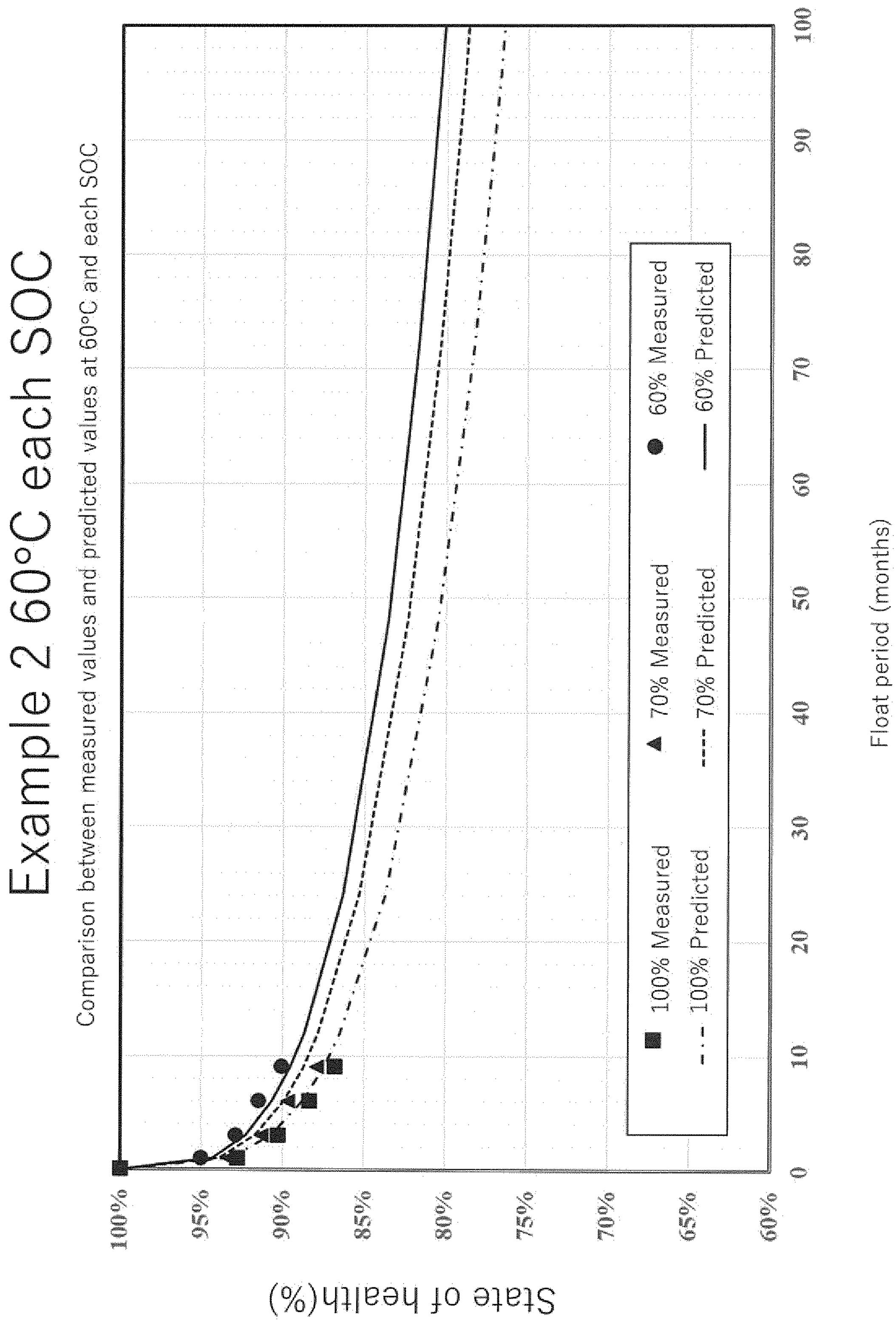

Example 2 60°C each SOC
Comparison between measured values and predicted values at 60°C and each SOC
State of health(%)
100%
95%
90%
85%
80%
75%
70%
65%
60%
0
10
20
30
40
50
60
70
80
90
100
Float period (months)
100% Measured
70% Measured
60% Measured
100% Predicted
70% Predicted
60% Predicted

Fig. 13

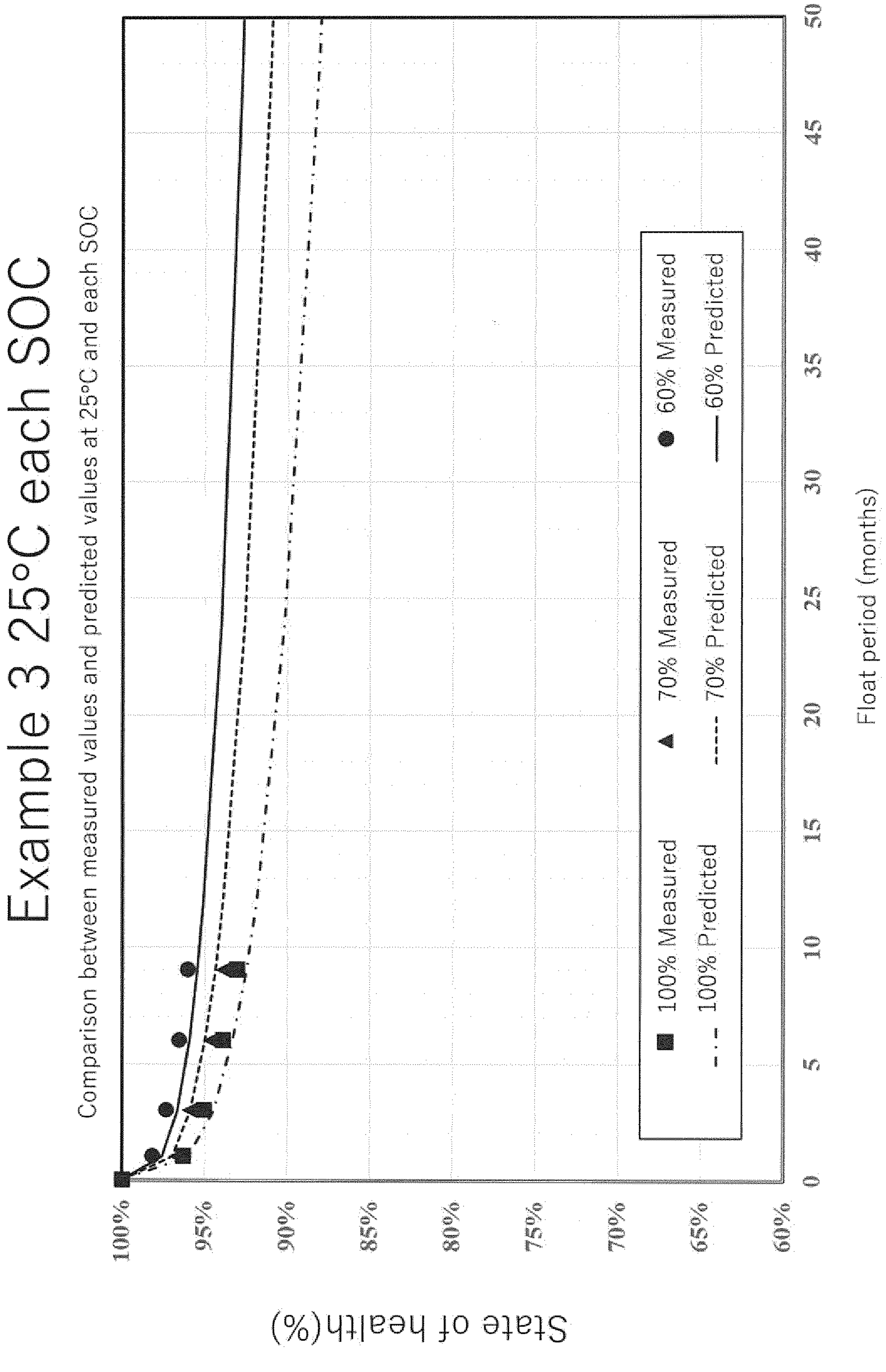
Example 3 25°C each SOC
Comparison between measured values and predicted values at 25°C and each SOC
State of health(%)
100%
95%
90%
85%
80%
75%
70%
65%
60%
0
5
10
15
20
25
30
35
40
45
50
Float period (months)
100% Measured
100% Predicted
70% Measured
70% Predicted
60% Measured
60% Predicted

Fig. 14

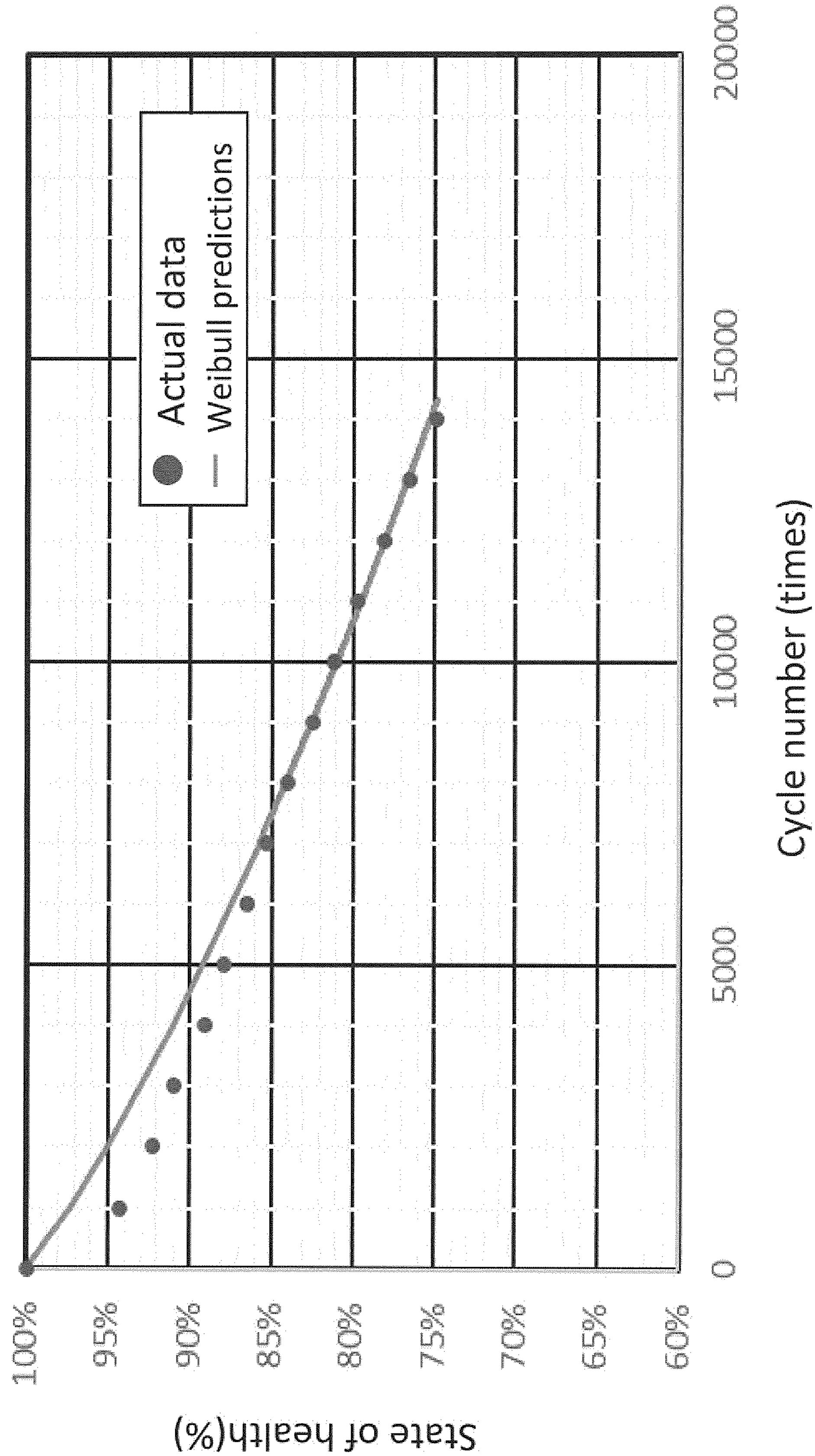
Actual data
Weibull predictions
State of health(%)
100%
95%
90%
85%
80%
75%
70%
65%
60%
0
5000
10000
15000
20000
Cycle number (times)

Fig. 15

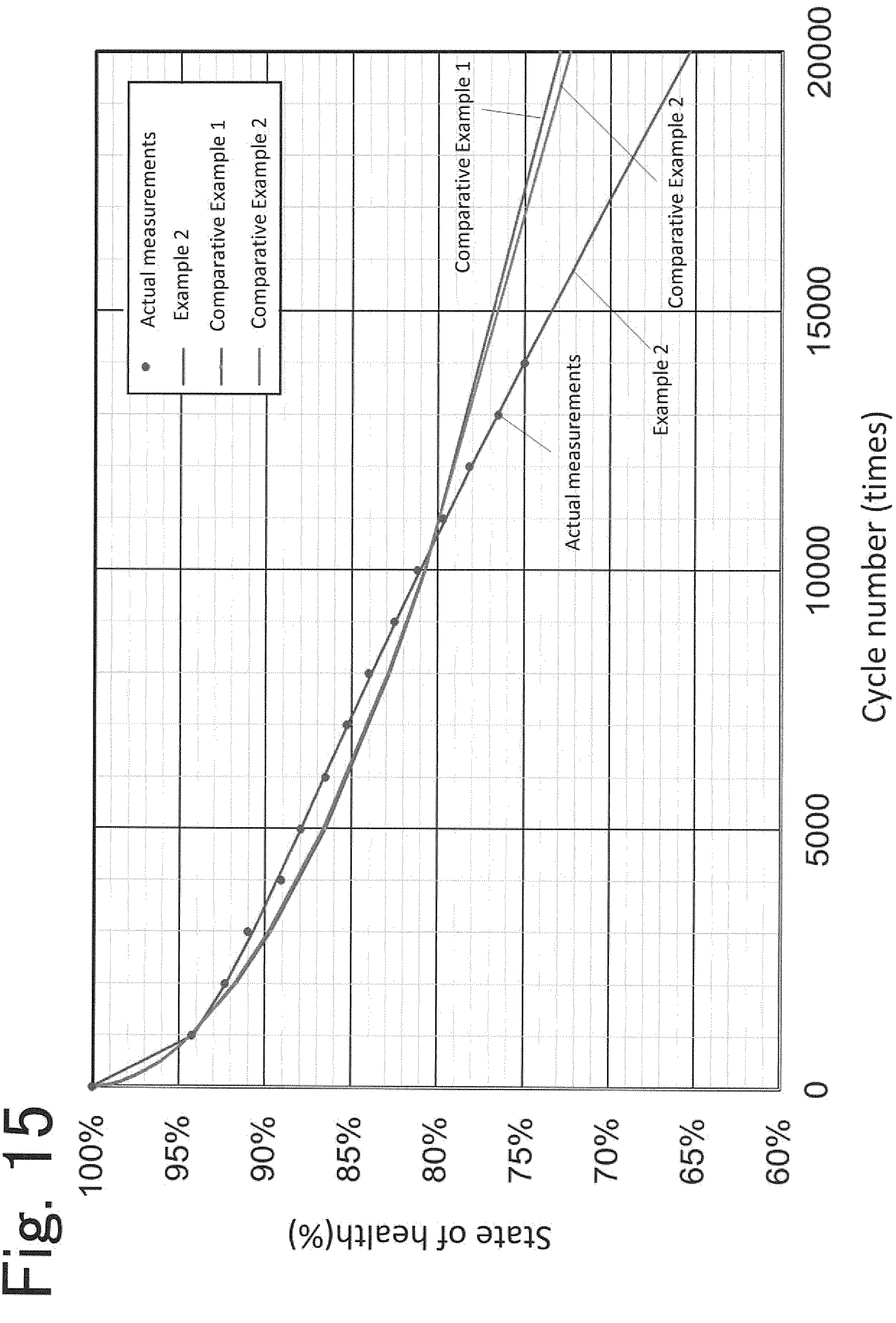

Actual measurements
Example 2
Comparative Example 1
Comparative Example 2
Comparative Example 1
Comparative Example 2
Actual measurements
Example 2
100%
95%
90%
85%
80%
75%
70%
65%
60%
State of health(%)
0
5000
10000
15000
20000
Cycle number (times)

Fig. 16

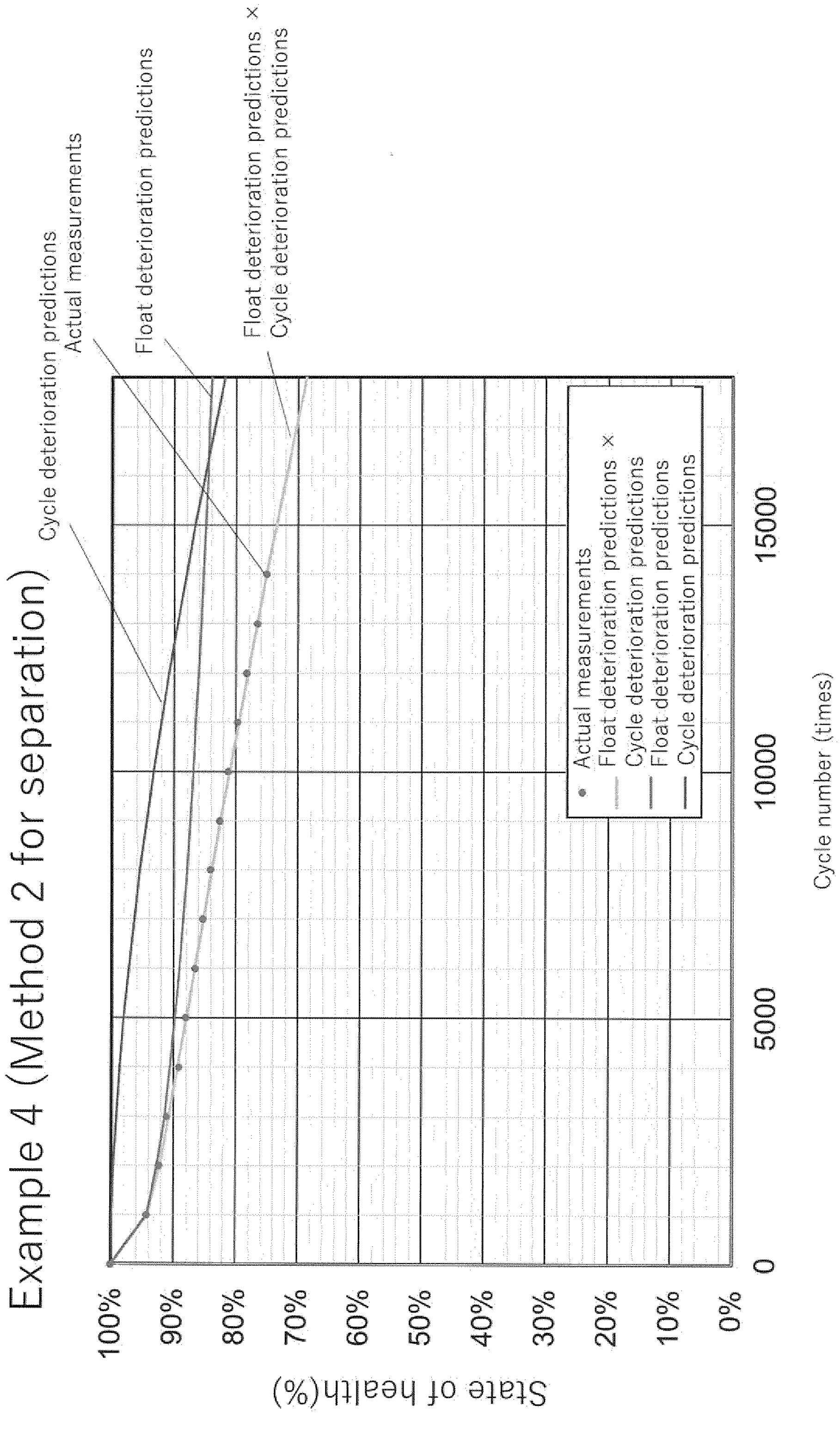
Example 4 (Method 2 for separation)
Cycle deterioration predictions
Actual measurements
Float deterioration predictions
Float deterioration predictions × Cycle deterioration predictions
Actual measurements
Float deterioration predictions ×
Cycle deterioration predictions
Float deterioration predictions
Cycle deterioration predictions
State of health(%)
100%
90%
80%
70%
60%
50%
40%
30%
20%
10%
0%
0
5000
10000
15000
Cycle number (times)

Fig. 17

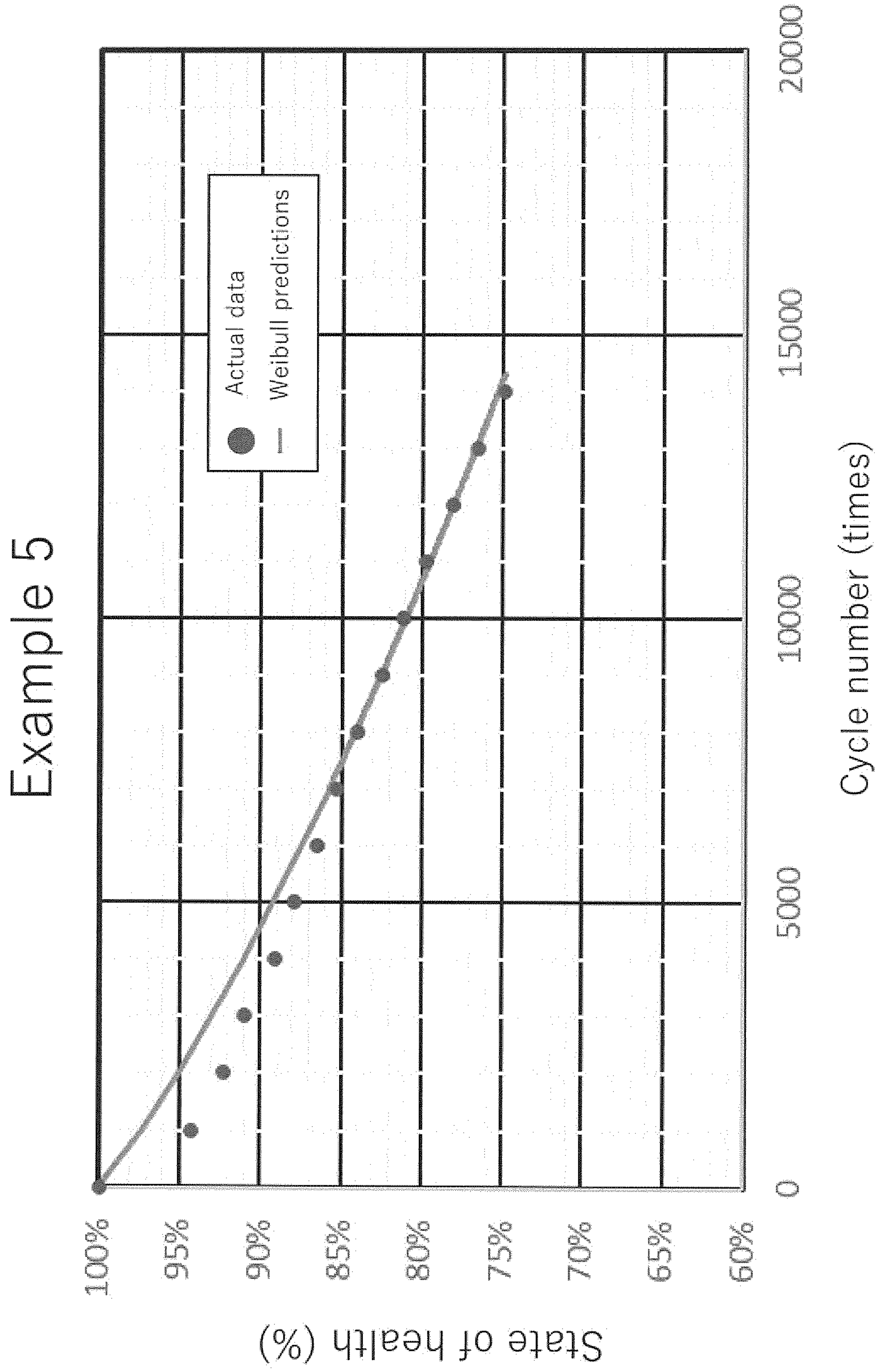

Example 5
Actual data
Weibull predictions
State of health (%)
100%
95%
90%
85%
80%
75%
70%
65%
60%
0
5000
10000
15000
20000
Cycle number (times)

**INTERNATIONAL SEARCH REPORT**

International application No.
**PCT/JP2022/031360**

**A. CLASSIFICATION OF SUBJECT MATTER**

***G01R 31/392***(2019.01)i; ***H01M 10/48***(2006.01)i; ***H02J 7/00***(2006.01)i
FI: G01R31/392; H01M10/48 P; H02J7/00 Q

According to International Patent Classification (IPC) or to both national classification and IPC

**B. FIELDS SEARCHED**

Minimum documentation searched (classification system followed by classification symbols)

G01R31/392; H01M10/48; H02J7/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br><br><br>A | JP 2017-34781 A (THE UNIVERSITY OF ELECTRO-COMMUNICATIONS) 09 February 2017 (2017-02-09)<br>paragraphs [0001], [0009], [0013]-[0015], [0032]-[0035], [0054]-[0119], fig. 1, 9, 13-21 | 1, 10-11<br><br><br>2-9 |
| A | JP 2018-186590 A (HITACHI, LTD.) 22 November 2018 (2018-11-22)<br>entire text, all drawings | 1-11 |
| A | 杉山秀幸,原富太郎,福永孝夫,河上清源. ワイブル則による新規寿命予測式. 第59回電池討論会 講演要旨集. The Electrochemical Society of Japan, Committee of Battery Technology, 26 November 2018, p. 212, non-official translation (SUGIYAMA, Hideyuki, HARA, Tomitaro, FUKUNAGA, Takao, KAWAKAMI, Kiyomoto. Weibull-Based Novel Lifetime Prediction Method. Proceedings of the 59th Battery Symposium in Japan.)<br>entire text | 1-11 |
| A | DE 102020201697 B3 (VOLKSWAGEN AKTIENGESELLSCHAFT) 29 April 2021 (2021-04-29)<br>entire text, all drawings | 1-11 |

☑ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **07 October 2022** | **25 October 2022** |
| Name and mailing address of the ISA/JP<br>**Japan Patent Office (ISA/JP)**<br>**3-4-3 Kasumigaseki, Chiyoda-ku, Tokyo 100-8915**<br>**Japan** | Authorized officer<br><br>Telephone No. |

Form PCT/ISA/210 (second sheet) (January 2015)

**INTERNATIONAL SEARCH REPORT**

International application No.
**PCT/JP2022/031360**

**C. DOCUMENTS CONSIDERED TO BE RELEVANT**

| Category* | Citation of document, with indication, where appropriate, of the relevant passages | Relevant to claim No. |
|---|---|---|
| A | US 2019/0212391 A1 (ROBERT BOSCH GMBH) 11 July 2019 (2019-07-11)<br>entire text, all drawings | 1-11 |
| P, A | 田口義晃,門脇悟志. パラメータを可変としたワイブル則によるLIBの温度変動に対応した容量予測法の検討. 電池討論会講演要旨集 第61回. 24 September 2021 (intake date), p. 1, non-official translation (TAGUCHI, Yoshiaki, KADOWAKI, Satoshi. Study of Weibull-Based LIB Temperature Fluctuation-Compatible Capacity Prediction Method with Parameter Variability. Proceedings of the 61st Battery Symposium in Japan.)<br>entire text | 1-11 |
| P, A | WO 2022/024885 A1 (HITACHI HIGH-TECH CORP.) 03 February 2022 (2022-02-03)<br>entire text, all drawings | 1-11 |

Form PCT/ISA/210 (second sheet) (January 2015)

**INTERNATIONAL SEARCH REPORT**
**Information on patent family members**

International application No.
**PCT/JP2022/031360**

| Patent document cited in search report | Publication date (day/month/year) | Patent family member(s) | Publication date (day/month/year) |
|---|---|---|---|
| JP 2017-34781 A | 09 February 2017 | (Family: none) | |
| JP 2018-186590 A | 22 November 2018 | (Family: none) | |
| DE 102020201697 B3 | 29 April 2021 | US 2021/0249704 A1<br>entire text, all drawings | |
| US 2019/0212391 A1 | 11 July 2019 | WO 2018/001602 A1<br>entire text, all drawings<br>DE 102016211898 A<br>CN 109313240 A | |
| WO 2022/024885 A1 | 03 February 2022 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2009052974 A


### Non-patent literature cited in the description


- Abstracts of Presentations. *The 59th Battery Symposium in Japan,* 26 November 2018, 212